# EUROPEAN PATENT APPLICATION

(11) **EP 4 791 166 A1**
(43) Date of publication of application: **12.08.2026**
(21) Application number: 26156640.0
(22) Date of filing: 05.02.2026
(51) Int. Cl.: H10K 59/80, H10K 59/126, H10K 59/122, H10K 59/35

(54) **DISPLAY DEVICE AND ELECTRONIC DEVICE INCLUDING THE SAME**

(30) Priority: 06.02.2025 KR 20250015247; 19.06.2025 KR 20250081319
(71) Applicant: Samsung Display Co., Ltd., Yongin-si, Gyeonggi-do (KR)
(72) Inventor: Choi, Yoonsun, Yongin-si, Gyeonggi-Do (KR); Kim, Kangsan, Yongin-si, Gyeonggi-Do (KR); Park, Sungjoo, Yongin-si, Gyeonggi-Do (KR); Yoo, Jewon, Yongin-si, Gyeonggi-do (KR); Chung, Jinkoo, Yongin-si, Gyeonggi-Do (KR); Choi, Jungmin, Yongin-si, Gyeonggi-Do (KR)
(74) Representative: Gulde & Partner

(57) **Abstract**

A display device (DD) includes a display panel (DP) including a base layer (BL), light emitting areas (LA) and a non-light emitting area (NLA). A pixel defining layer (PDL) is disposed on the base layer (BL) and has pixel openings (OH) defined therein that overlaps the light emitting areas (LA). Light emitting elements (OLED, ED) are disposed in the pixel openings (OH). A light control layer (CCL) is disposed on the display panel (DP) and includes a light blocking pattern (BM). The light blocking pattern (BM) includes extensions (PT1), each of which extends in a first direction (DR1) to overlap the light emitting areas (LA) and the non-light emitting area (NLA), the extensions (PT1) being spaced apart in a second direction (DR2) that is perpendicular to the first direction (DR1). The light blocking pattern (BM) also includes connections that overlap the non-light emitting area (NLA) and that are disposed between extensions (PT1) that are adjacent to each other.

## Description

### CROSS-REFERENCE TO RELATED APPLICATIONS

### BACKGROUND

Display devices are used in various electronic devices such as televisions, mobile phones, tablet computers, and electronic devices included in vehicles. Ongoing efforts are being made to develop improved display devices due to their importance in a wide range of applications. Depending on a usage environment, information on display devices may need to be protected or may otherwise need to be controlled to comply with various regulations, such as safety regulations. To fulfill such objectives, a range of viewing angles of the display device must be limited. Accordingly, studies on stack structures of display devices and optical members included in display devices have been conducted in order to limit the viewing angles of display devices. However, there is a need for further improvements in display device technology to limit viewing angles of display devices.

### BRIEF SUMMARY

Embodiments of the present disclosure include a display device configured to control a viewing angle by reducing light extraction in directions that are at a wide viewing angle. A display device according to embodiments of the present disclosure may include a light control layer that controls a light extraction direction.

Embodiments of the present disclosure provide a display device that improves reliability by preventing a defect in a light blocking pattern included in the display device while minimizing a decrease in the luminance of the display device.

According to an embodiment, a display device includes a display panel. The display panel includes a base layer including light emitting areas and a non-light emitting area, a pixel defining layer disposed on the base layer and having pixel openings defined therein to overlap the light emitting areas, and light emitting elements disposed in the pixel openings. The display device also includes a light control layer disposed on the display panel, the light control layer including a light blocking pattern. The light blocking pattern includes extensions, each of which extends in a first direction to overlap the light emitting areas and the non-light emitting area. The extensions are arranged so that they are spaced apart in a second direction that crosses the first direction. The light blocking pattern also includes one or more connections that overlap the non-light emitting area and that are disposed between adjacent extensions.

The connections may be oriented so that each connection of the connections extends in a direction perpendicular to the first direction.

The connections may extend in an extension direction crossing the first direction, and a straight line parallel to the first direction and a straight line parallel to the extension direction of the connections may form an acute angle.

The light control layer may be a first light control layer among a plurality of light control layers. The plurality of light control layers may be sequentially disposed in a direction away from the display panel. A total number of the light control layers may be 2 or more, or 5 or less. The light blocking patterns included in the light control layers may overlap one another when viewed from above a plane, i.e., a direction perpendicular to and facing an upper surface of the display device.

For example, the light control layer may be a first light control layer. The display device may further include one or more additional light control layers. The one or more additional light control layers may include one or more of a second light control layer, a third light control layer, a fourth light control layer or a fifth light control layer. The one or more additional light control layers may each include a light blocking pattern. The first light control layer and the one or more additional light control layers may be sequentially disposed in a direction away from the display panel. The light blocking patterns included in the first light control layer and the one or more additional light control layers may overlap each other in a third direction perpendicular to both the first direction and the second direction.

A luminance at an angle of 35° (or an angle between 30° and 40°) relative to the second direction may be 5% or less (preferably 3% or less) of a luminance of the display panel in a front direction, i.e., a direction perpendicular to and facing an upper surface of the display device.

The extensions and the connections may be formed together through the same process and may include the same material.

The extensions may be spaced apart from one another at a predetermined interval in the second direction, and the connections may be spaced apart from one another at a predetermined interval in the first direction.

The light emitting element may include first type light emitting elements and second type light emitting elements. The light emitting area may include a first-first light emitting area, a second-first light emitting area, and a third-first light emitting area through which light by the first type light emitting elements may be emitted, and may include a first-second light emitting area, a second-second light emitting area, and a third-second light emitting area through which light by the second type light emitting elements may be emitted. The first-first light emitting area may have a larger planar area than the first-second light emitting area, the second-first light emitting area may have a larger planar area than the second-second light emitting area, and the third-first light emitting area may have a larger planar area than the third-second light emitting area.

The display device may switch between a first mode in which only the first type light emitting elements operate and a second mode in which the first type light emitting elements do not operate and only the second type light emitting elements operate.

The display device may further include a light blocking barrier that is disposed on the pixel defining layer and that may at least partially surround the first-second light emitting area, the second-second light emitting area, and the third-second light emitting area when viewed from above a plane, i.e., from a direction that faces an upper surface of the display device, and the light blocking barrier may be formed through the same process as the light blocking pattern and may include the same material as the light blocking pattern.

The light emitting area may include a first light emitting area that emits red light, a second light emitting area that emits green light, and a third light emitting area that emits blue light, and the light blocking pattern may further include a first expanding connection including a first extending connection and a second extending connection disposed side by side in the second direction to continuously connect three adjacent extensions.

The light blocking pattern may further include second expanding connections, each of which may include a first extending connection, a second extending connection, and a third extending connection disposed side by side in the second direction to continuously connect four adjacent extensions.

The display panel may include pixel units including the light emitting elements and arranged in the first direction. A width of the pixel units in the first direction may be defined as a unit pitch, and the second expanding connections may be spaced apart from each other at an interval of one unit pitch or more and four unit pitches or less in the first direction.

According to an embodiment, a display device includes a display panel including a display area and a non-display area adjacent to the display area and a first light control layer disposed on the display panel and including a light blocking pattern and an insulating layer that covers the light blocking pattern. The light blocking pattern includes extensions that extend in a first direction and that are arranged such that each extension is spaced apart in a second direction crossing the first direction, the extensions being disposed in the display area. The light blocking pattern also includes first outer connections disposed in the non-display area that are connected with ends of the extensions, a width of each of the first outer connections being greater than a width of each of the extensions.

The first outer connections may be formed together with the extensions through the same process and may include the same material as the extensions.

The light blocking pattern may further include second outer connections that extend in the first direction and that may be disposed in the non-display area and may be connected with ends of the first outer connections.

The first outer connections may have a width of 1400 µm to 1600 µm in the first direction, and the second outer connections may have a width of 2100 µm to 2300 µm in the second direction.

According to an embodiment, an electronic device includes a display device, an electronic module that provides an electrical signal to the display device, and a window module disposed on the display device. The display device includes a display panel including a base layer including light emitting areas and a non-light emitting area, a pixel defining layer disposed on the base layer and having pixel openings defined therein to overlap the light emitting areas, and light emitting elements disposed in the pixel openings and a light control layer disposed on the display panel and including a light blocking pattern. The light blocking pattern includes extensions, each of which extends in a first direction to overlap the light emitting areas and the non-light emitting area, the extensions being arranged such that each extension is spaced apart in a second direction crossing the first direction. The light blocking pattern also includes connections that overlap the non-light emitting area and are disposed between the extensions adjacent to each other in the second direction.

The light control layer may be a first light control layer among a plurality of light control layers. The plurality of light control layers may be sequentially disposed in a direction away from the display panel. A total number of the light control layers may be 2 or more, or 5 or less.

For example, the light control layer may be a first light control layer. The display device may further include one or more additional light control layers. The one or more additional light control layers may include one or more of a second light control layer, a third light control layer, a fourth light control layer or a fifth light control layer. The one or more additional light control layers may each include a light blocking pattern. The first light control layer and the one or more additional light control layers may be sequentially disposed in a direction away from the display panel.

The electronic device may further include power supply module such as a power adaptor or a battery device, and the electronic device may be equipped in a transport device such as a vehicle.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE FIGURES

The above and other objects and features of the present disclosure will become apparent by describing in detail embodiments thereof with reference to the accompanying drawings.
FIG. 1 is a block diagram of an electronic device according to an embodiment of the present disclosure.
FIGS. 2A and 2B illustrate schematic views of electronic devices according to various embodiments.
FIG. 3 is a sectional view of an electronic device according to an embodiment of the present disclosure.
FIG. 4 is a plan view illustrating a partial area of a display device according to an embodiment of the present disclosure.
FIG. 5A is an enlarged plan view of part of the partial area of FIG. 4.
FIG. 5B is a sectional view corresponding to line I-I' of FIG. 5A.
FIG. 5C is a sectional view corresponding to line II-II' of FIG. 5A.
FIG. 6A is a plan view illustrating a partial area of a display device according to a comparative example.
FIG. 6B is a plan view illustrating a partial area of a display device according to an embodiment of the present disclosure.
FIG. 6C is a schematic view illustrating different viewing areas according to the present disclosure.
FIG. 7 is a plan view illustrating a partial area of a display device according to an embodiment of the present disclosure.
FIG. 8 is a plan view illustrating a partial area of a display device according to an embodiment of the present disclosure.
FIG. 9 is a plan view illustrating a partial area of a display device according to an embodiment of the present disclosure.
FIG. 10A is a plan view illustrating a partial area of a display device according to an embodiment of the present disclosure.
FIG. 10B is a sectional view corresponding to line III-III' of FIG. 10A.
FIG. 11A is a plan view illustrating a partial area of a display device according to an embodiment of the present disclosure.
FIG. 11B is a sectional view corresponding to line IV-IV' of FIG. 11A.
FIG. 12 is a plan view illustrating a partial area of a display device according to an embodiment of the present disclosure.
FIG. 13 is a plan view illustrating a partial area of a display device according to an embodiment of the present disclosure.
FIG. 14 is a plan view illustrating a partial area of a display device according to an embodiment of the present disclosure.
FIG. 15 is an enlarged plan view of a part of the partial area of the display device in FIG. 14.
FIGS. 16 and 17 are plan views of a display device according to an embodiment of the present disclosure.
FIG. 18 is a plan view of a display device according to an embodiment of the present disclosure.
FIG. 19 is a plan view of a display device according to an embodiment of the present disclosure.

### DETAILED DESCRIPTION

It is contemplated that various changes can be made to the present disclosure. Thus, while specific embodiments are illustrated in the drawings and described as examples herein, it should be understood that the present disclosure is not to be construed as being limited thereto and covers all modifications, equivalents, and alternatives falling within the scope of the present disclosure as defined by the appended claims.

In the present disclosure, when a component (or, an area, a layer, a part, etc.) is referred to as being "on", "connected to" or "coupled to" another component, this means that the component may be directly on, connected to, or coupled to the other component or a third component may be present therebetween.

In the drawings, the thicknesses, proportions, and dimensions of components may be exaggerated for effective description. As used herein, the term "and/or" includes one or more combinations of components, each combination defined by one or more components, up to and including all identified components.

Terms such as first, second, and the like may be used to describe various components, but the components are not limited by the use of such terms. The terms may be used solely for purposes of distinguishing one component from other components. For example, without departing the scope of the present disclosure as defined by the appended claims, a first component may be referred to as a second component, and similarly, the second component may also be referred to as the first component. The terms of a singular form may include plural forms unless otherwise specified.

In addition, terms such as "below", "under", "above", and "over" are used to describe a relationship between components illustrated in the drawings. The terms are relative concepts and are described based on directions illustrated in the drawing or drawings.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, embodiments of the present disclosure will be described with reference to the accompanying drawings.

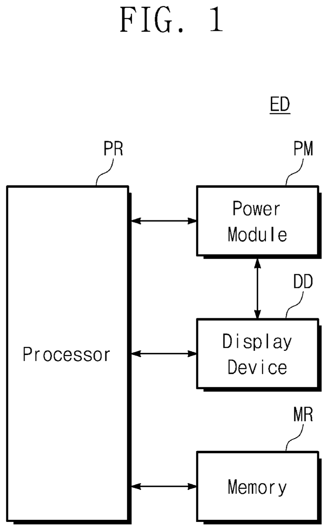

FIG. 1 is a block diagram of an electronic device according to an embodiment of the present disclosure.

The electronic device according to the present disclosure may be provided in various forms. The electronic device according to some embodiments of the present disclosure may include modules or devices having functions in addition to those of a display device included with the electronic device.

Referring to FIG. 1, the electronic device ED according to an embodiment may include a display device DD, a processor PR, a memory MR, and a power module PM. Throughout the present disclosure, a module that provides an electronic signal to the display device DD or receives an electrical signal from the display device DD may be collectively referred to as an "electronic module".

The processor PR may include at least one of a central processing unit (CPU), an application processor (AP), a graphic processing unit (GPU), a communication processor (CP), an image signal processor (ISP), or a controller.

Data information required for operation of the processor PR or the display device DD may be stored in the memory MR. When the processor PR executes an application stored in the memory MR, an image data signal and/or an input control signal may be transferred to the display device DD, and the display device DD may process the received signal and may output image information through a display screen.

The power module PM may include a power supply module, such as a power adaptor or a battery device, and a power conversion module that converts power supplied by the power supply module and generates power required for operation of the electronic device ED.

Some of the separate modules functionally included in one module may be included in the display device DD, and the others may be provided separately from the display device DD in the electronic device ED.

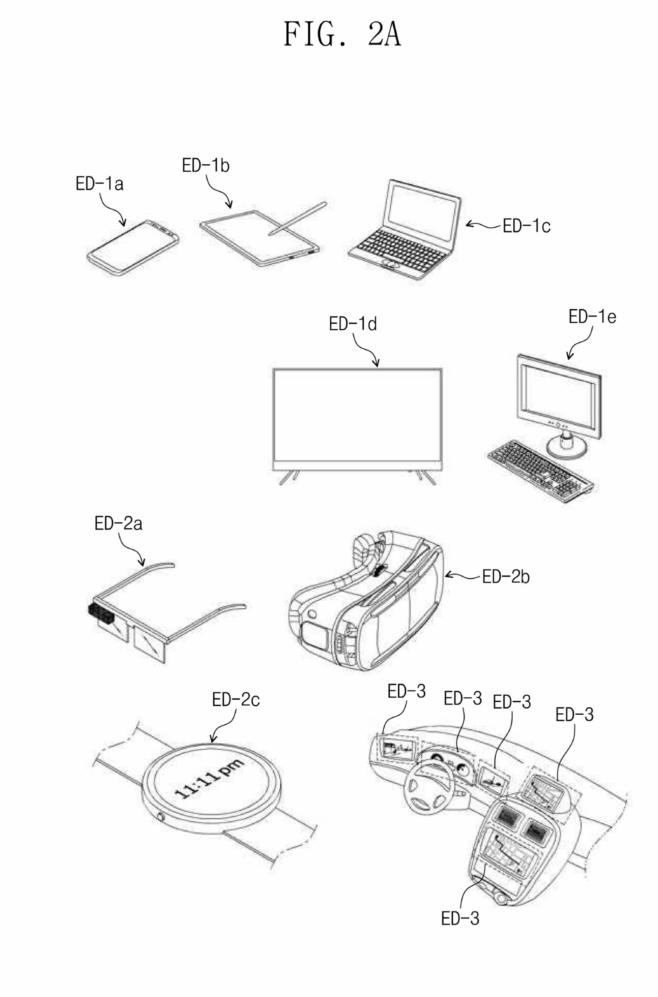

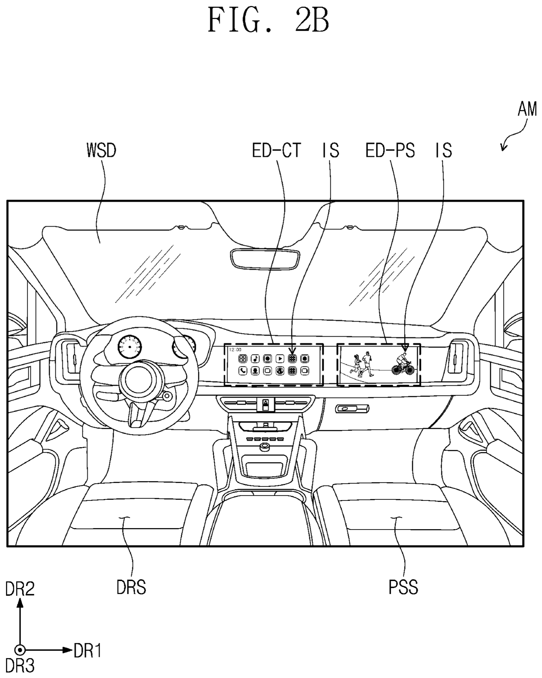

FIGS. 2A and 2B illustrate schematic views of electronic devices according to various embodiments.

Referring to FIG. 2A, electronic devices according to various embodiments may be wearable electronic devices, such as smart glasses ED-2a, a head mounted display ED-2b, or a smart watch ED-2C, which includes a display module, as well as electronic devices for displaying an image, such as a smart phone ED-1a, a tablet PC ED-1b, a laptop computer ED-1c, a TV ED-1d, or a desk monitor ED-1e.

In addition, electronic devices according to various embodiments may be equipped in transport devices such as vehicles to provide various pieces of information to users through images displayed on such transport devices. For example, an electronic device according to the present disclosure may be provided in the form of a vehicle electronic device ED-3 including a display module such as a center information display (CID) disposed on an instrument panel, a center fascia, or a dashboard of a vehicle, or a room mirror display.

FIG. 2B is a view illustrating the interior of a vehicle in which an electronic device of an embodiment is disposed. In FIG. 2B, a state in which a first electronic device ED-PS and a second electronic device ED-CT are disposed inside a vehicle AM is illustrated as an example. The electronic devices ED-CT and ED-PS of an embodiment may be disposed inside the vehicle AM to provide various pieces of information to a user in a driver's seat DRS or a passenger seat PSS.

The electronic devices ED-CT and ED-PS may display images on display surfaces IS. The display surfaces IS, on which the images are displayed, may correspond to the front surfaces of the electronic devices ED-CT and ED-PS. The images may include a still image as well as a dynamic image.

The display surfaces IS may be oriented parallel to a plane that is coincident with a first direction DR1 and a second direction DR2 crossing the first direction DR1. However, embodiments of the present disclosure are not limited thereto, and the display surfaces IS of the electronic devices ED-CT and ED-PS may include a curved surface to reflect the design of the vehicle interior or may include a flat surface inclined with respect to the plane that is coincident with the first direction DR1 and the second direction DR2.

The normal direction of the display surfaces IS, that is, the thickness direction of the electronic devices ED-CT and ED-PS, is indicated by a third direction DR3. Throughout the present disclosure, the first direction DR1 may be referred to as a "left-right direction", the second direction DR2 may be referred to as an "up-down direction", and the third direction DR3 may be referred to as a "thickness direction".

Throughout the present disclosure, front surfaces (or, upper surfaces) and rear surfaces (or, lower surfaces) of members constituting the electronic device ED (refer to FIG. 1) may be defined based on the third direction DR3. The front surfaces (or, the upper surfaces) and the rear surfaces (or, the lower surfaces) of the members constituting the electronic device ED may be opposite each other in the third direction DR3, and the normal directions of the front surfaces and the rear surfaces may be substantially parallel to the third direction DR3. The separation distances between the front surfaces and the rear surfaces defined in the third direction DR3 may correspond to the thicknesses of a respective member of an electronic device ED including any member or component of a display device included therein.

In addition, the expression "on a plane" as used herein may mean that a referenced member or component is viewed in the third direction DR3. The expression "on a cross-section" used herein may mean that a referenced member or component is viewed in the first direction DR1 or the second direction DR2.

FIG. 2B illustrates an example where the display surfaces IS have a rectangular shape on the plane. However, this is only one illustrative example, and the display surfaces IS may have various shapes and as such the display surfaces IS are not limited to any one embodiment.

Throughout the present disclosure, it should be understood that when reference is made to the electronic device ED (refer to FIG. 1) such referenced electronic device ED may be configured to switch between a "first mode" and a "second mode". The electronic device ED (refer to FIG. 1) may provide different viewing angles in the first mode and the second mode.

Referring to FIG. 2B, the first electronic device ED-PS may be disposed at a position facing the passenger seat PSS. The first electronic device ED-PS may display not only information required during driving of the vehicle, such as vehicle status information, vehicle interior operation information, and navigation information, but also various pieces of information irrelevant to the driving of the vehicle.

However, the image displayed on the first electronic device ED-PS does not need to be delivered to the user in the driver's seat DRS for safety during the driving of the vehicle. That is, the range of the lateral viewing angle in which the image displayed on the first electronic device ED-PS is visually recognized may be controlled so as not to affect the driver. This control of a lateral viewing angle to limit viewing by the driver may be guided by consideration of the field of view of the user in the driver's seat DRS.

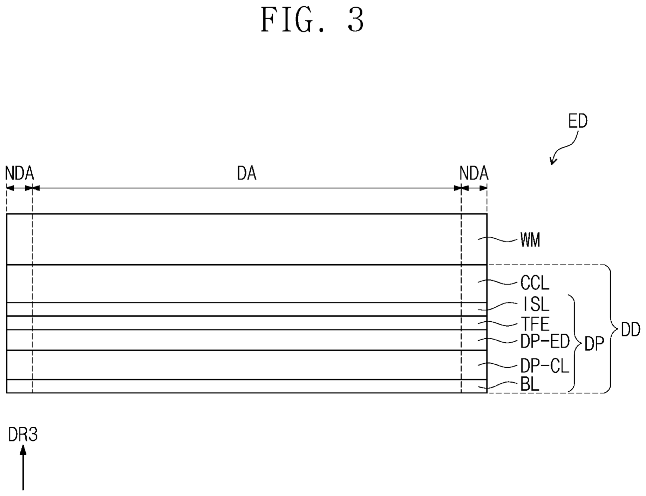

For example, the viewing angle in the left-right direction that the first electronic device ED-PS provides in the second mode may be smaller than the viewing angle in the left-right direction that the first electronic device ED-PS provides in the first mode. The image displayed on the first electronic device ED-PS may be visually recognized by the driver in the first mode and may not be visually recognized by the driver in the second mode. Accordingly, an optical path may be limited by a light control layer CCL (refer to FIG. 3) to be described below, and thus the first electronic device ED-PS may advantageously provide an image with high visibility to the user without disturbing the driver.

The second electronic device ED-CT may be a center information display (CID). The second electronic device ED-CT may be mounted on the dashboard between the driver's seat DRS and the passenger seat PSS. The second electronic device ED-CT may integrally show various pieces of information to the user in the driver's seat DRS or the passenger seat PSS.

In the case of the second electronic device ED-CT, it may be necessary to limit the viewing angle in the up-down direction (e.g., the second direction DR2). When the image displayed on the second electronic device ED-CT is displayed in a wide angle range in the up-down direction, light emitted from the second electronic device ED-CT may reach a windshield WSD and may generate reflected light. In this case, the user's view may be obstructed by the reflected light. In an embodiment, an optical path in the up-down direction may be limited by the light control layer CCL (refer to FIG. 3) to be described below, and thus the second electronic device ED-CT of the vehicle AM may decrease light delivered to the windshield WSD to provide an image with high visibility to the user.

For example, the viewing angles in the up-down direction that the second electronic device ED-CT provides in the first mode and the second mode may be limited. However, without being limited thereto, a limitation in viewing angle in the first mode or the second mode may include a limitation in viewing angle in any combination of the up, down, left, and right directions, i.e., in one, two, three or four directions). In some examples, the limitation in viewing angles in the first mode may be different from the limitation in viewing angles in the second mode.

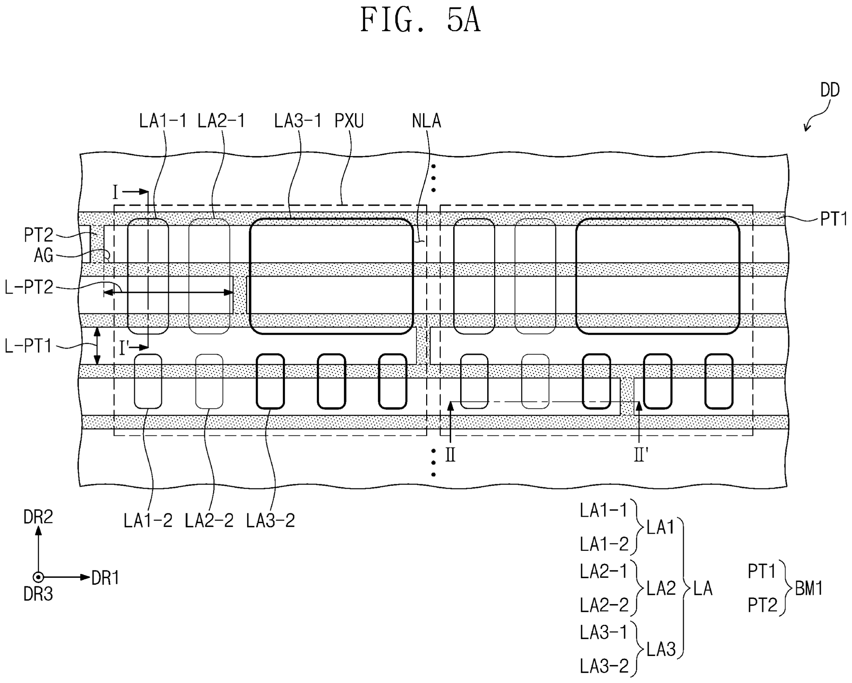

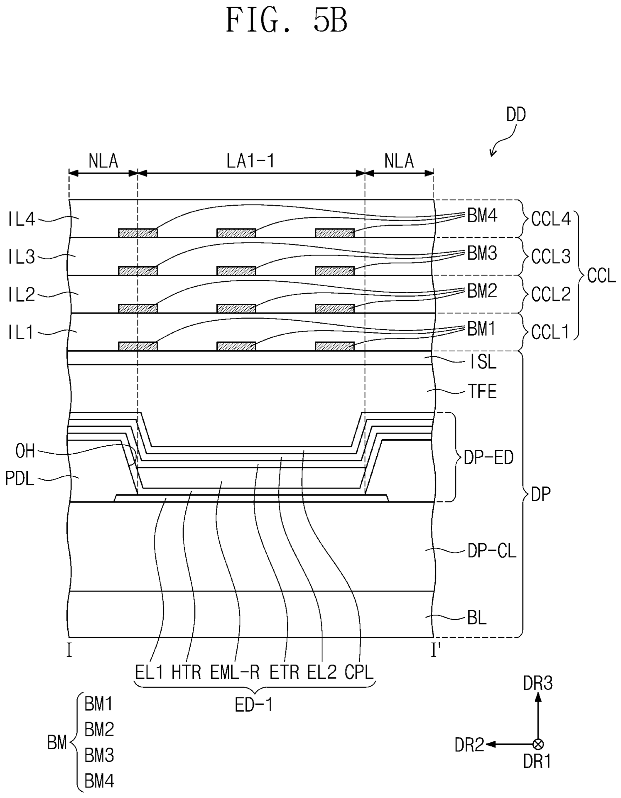

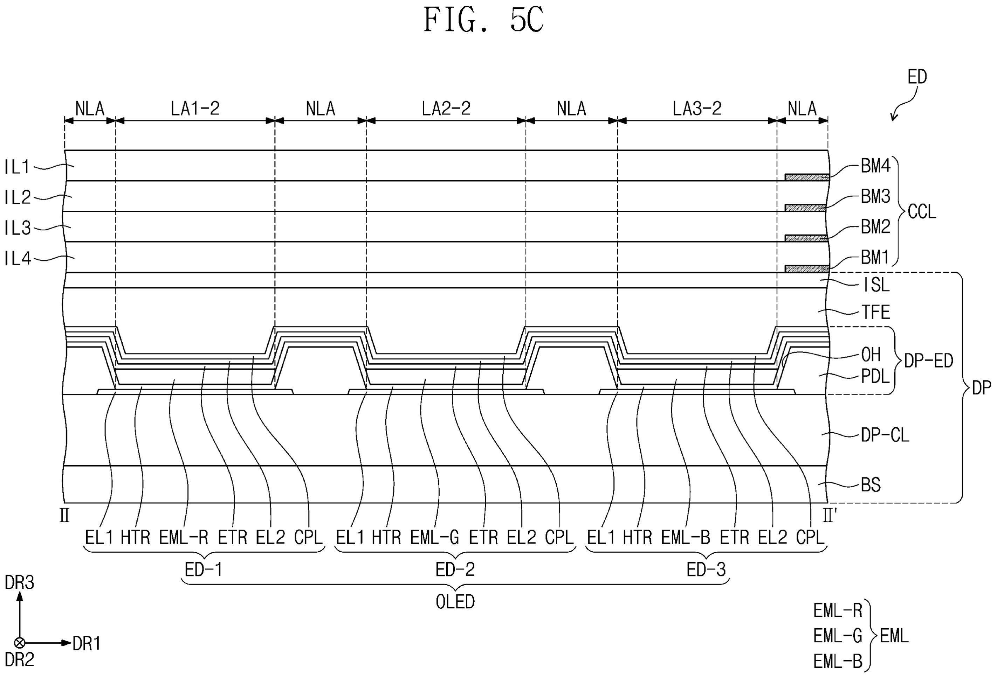

However, in a process of forming the light control layer CCL (refer to FIG. 3), a fine pattern that limits a viewing angle without reducing the user's visibility has to be formed, and therefore a defect may occur in a manufacturing process of the light control layer CCL (refer to FIG. 3) if the fine pattern is not adequately formed. According to one embodiment of an electronic device of the present disclosure, in a process of forming light blocking patterns BM (refer to FIG. 5) included in the light control layer CCL (refer to FIG. 3), a part of the light blocking patterns BM (refer to FIG. 5B) may be effectively prevented from being ripped.

FIG. 3 is a sectional view of an electronic device according to an embodiment of the present disclosure.

The electronic device ED may include the display device DD and a window module WM. The window module WM may be disposed on the display device DD.

The window module WM may be disposed on the display device DD and may cover the display device DD. The front surface of the window module WM may define the display surface IS of the electronic device ED. The window module WM may have a shape corresponding to the shape of the display device DD.

The window module WM may include a substrate or film including a glass or polymer material. In addition, the window module WM may further include a functional layer, such as a protective film, which is disposed on a substrate or a film that serves as a base. The window module WM may further include an adhesive layer for coupling the window module WM to the display device DD. For example, the adhesive layer may be an optically clear adhesive layer. However, in the electronic device ED according to an embodiment, the window module WM may be omitted.

The display device DD may include a display panel DP and the light control layer CCL.

The display panel DP may be a component that substantially generates an image. The display panel DP included in the electronic device ED according to this embodiment may be an organic light emitting display panel, an inorganic light emitting display panel, an organic-inorganic light emitting display panel, a quantum-dot display panel, a micro-LED display pane, or a nano-LED display panel. In this embodiment, it will be exemplified that the display panel DP is an organic light emitting display panel. However, embodiments of the present disclosure are not limited thereto.

The display panel DP may include a base layer BL, a circuit element layer DP-CL, a display element layer DP-ED, an encapsulation layer TFE, and an input sensing layer ISL.

In the display panel DP, the base layer BL may be a member that provides a base surface on which the display element layer DP-ED is disposed. The base layer BL may be rigid or flexible. The base layer BL may be a glass substrate, a metal substrate, or a polymer substrate. However, embodiments of the present disclosure are not limited thereto, and the base layer BL may be an inorganic layer, an organic layer, or a composite layer.

The base layer BL may have a multi-layer structure as well as a single-layer structure. For example, the base layer BL may have a three-layer structure including a polymer resin layer, an adhesive layer, and a polymer resin layer. In particular, the polymer resin layers may include a polyimide-based resin. Alternatively, the polymer resin layers may include at least one of an acrylic resin, a vinyl resin, an epoxy resin, a urethane-based resin, a celluosic resin, a siloxane-based resin, or a perylene-based resin. Meanwhile, reference to a "~~"-based resin herein means a resin including a "~~" functional group.

The circuit element layer DP-CL may be disposed on the base layer BL. The circuit element layer DP-CL may include an insulating layer, a semiconductor pattern, a conductive pattern, and a signal line. The circuit element layer DP-CL may include a plurality of transistors (not illustrated) that are formed of the semiconductor pattern, the conductive pattern, and the signal line. Each of the transistors (not illustrated) may include a control electrode, an input electrode, and an output electrode. For example, the circuit element layer DP-CL may include a switching transistor and a driving transistor for driving a light emitting element OLED (refer to FIG. 5C).

The display element layer DP-ED may be disposed on the circuit element layer DP-CL. Light generated from the display element layer DP-ED may pass through the light control layer CCL over the display element layer DP-ED and may be emitted to the upper surface of the electronic device ED. The display element layer DP-ED may include the light emitting element OLED (refer to FIG. 5C).

The encapsulation layer TFE may be disposed on the display element layer DP-ED. The encapsulation layer TFE may perform a function of preventing foreign matter such as moisture and oxygen from infiltrating into the display element layer DP-ED. The encapsulation layer TFE may have a structure in which organic layers and inorganic layers are alternately stacked one above another.

The light control layer CCL may be disposed over the display element layer DP-ED. The light control layer CCL may control the light extraction direction of light emitted from the display element layer DP-ED. The electronic device ED according to an embodiment, including the light control layer CCL, may exhibit high luminance and excellent display quality in a limited range of viewing angles by limiting light widely emitted in the "left-right direction" or limiting light widely emitted in the "up-down direction".

The electronic device ED may include a display area DA and a non-display area NDA adjacent to the display area DA. In this embodiment, the non-display area NDA may be an area surrounding the display area DA. However, embodiments of the present disclosure are not limited thereto. For example, the non-display area NDA may be omitted. In other examples, the non-display area NDA may not surround the display area DA.

The input sensing layer ISL may be disposed under the light control layer CCL. The input sensing layer ISL may obtain coordinate information of an external input. The input sensing layer ISL may sense the external input using a capacitive method, an electromagnetic induction method, or a pressure sensing method.

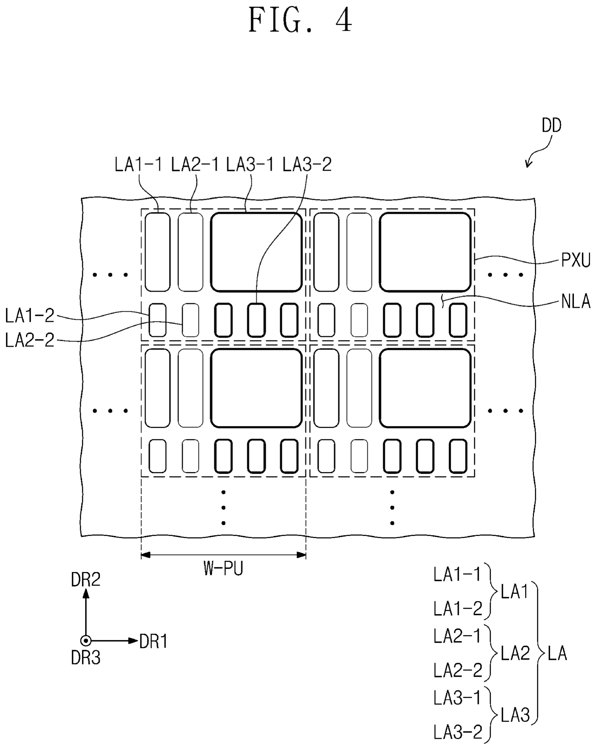

FIG. 4 is a plan view illustrating a partial area of the display device according to an embodiment of the present disclosure.

Referring to FIG. 4, the display device DD according to this embodiment may include a light emitting area LA and a non-light emitting area NLA adjacent to the light emitting area LA. The light emitting area LA may be defined as an area where the upper surface of a first electrode EL1 is exposed by a pixel opening OH (refer to FIG. 5B) to be described below. The light emitting area LA may include first light emitting areas LA1-1 and LA1-2, second light emitting areas LA2-1 and LA2-2, and third light emitting areas LA3-1 and LA3-2.

In this embodiment, the first light emitting areas LA1-1 and LA1-2 may be red light emitting areas that emit red light, the second light emitting areas LA2-1 and LA2-2 may be green light emitting areas that emit green light, and the third light emitting areas LA3-1 and LA3-2 may be blue light emitting areas that emit blue light. However, embodiments of the present disclosure are not limited thereto. For example, the display device DD may further include white light emitting areas that emit white light.

In this embodiment, a first light emitting area LA1 may include a first-first light emitting area LA1-1 and a first-second light emitting area LA1-2. A second light emitting area LA2 may include a second-first light emitting area LA2-1 and a second-second light emitting area LA2-2. A third light emitting area LA3 may include a third-first light emitting area LA3-1 and a third-second light emitting area LA3-2. The first-first light emitting area LA1-1 may have a larger planar area, i.e., emission surface area than the first-second light emitting area LA1-2, the second-first light emitting area LA2-1 may have a larger planar area (emission surface area) than the second-second light emitting area LA2-2, and the third-first light emitting area LA3-1 may have a larger planar area (emission surface area) than the third-second light emitting area La3-2. In each of the above comparisons of planar area, the planar area is an area in a plane coincident with the first direction DR1 and the second direction DR2.

In this embodiment, the light emitting element OLED (refer to FIG. 5C) may include a "first type light emitting element" and a "second type light emitting element". Throughout the present disclosure, these may also respectively be referred to as a "first type of light emitting element" and a "second type of light emitting element." In this case, each of the first-first light emitting area LA1-1, the second-first light emitting area LA2-1, and the third-first light emitting area LA3-1 may be an area where light by the "first type light emitting element" is emitted. Each of the first-second light emitting area LA1-2, the second-second light emitting area LA2-2, and the third-second light emitting area LA3-2 may be an area where light by the "second type light emitting element" is emitted.

The "first type light emitting element" and the "second type light emitting element" may be operated differently. For example, the first electronic device ED-PS (refer to FIG. 2B) may operate both the "first type light emitting element" and the "second type light emitting element" in the first mode and may operate only the "second type light emitting element" without operating the "first type light emitting element" in the second mode.

In addition, the second electronic device ED-CT (refer to FIG. 2B) may operate, in the first mode and the second mode, both the "first type light emitting element" and the "second type light emitting element", only the "first type light emitting element", or only the "second type light emitting element". In some examples, the type of light emitting elements, or the combination of types of light emitting elements, operated in the first mode and the second mode may be different from each other.

However, without being limited thereto, the "first type light emitting element" and the "second type light emitting element" may be changed to be differently operated as needed. Accordingly, the visibility of the electronic device ED (refer to FIG. 1) from the driver's seat DRS (refer to FIG. 2B) and the passenger seat PSS (refer to FIG. 2B) may be adjusted.

The non-light emitting area NLA may be defined as an area obtained by excluding the light emitting area LA from the display area DA (refer to FIG. 3). The non-light emitting area NLA may be expressed as a "peripheral area". The peripheral area NLA may be disposed around the light emitting area LA. The peripheral area NLA may set the boundary of the light emitting area LA.

In this embodiment, pixel units PXU may be arranged in the first direction DR1 and the second direction DR2 in the display area DA (refer to FIG. 4). The pixel units PXU may define pixel rows and pixel columns.

Each of the pixel units PXU may include at least one pixel. The pixel unit PXU may include a first pixel, a second pixel, and a third pixel that emit light in different wavelength ranges. The first pixel, the second pixel, and the third pixel may output red light, green light, and blue light, respectively.

As shown in FIG. 4, the width of the pixel unit PXU in the first direction DR1 may be defined as a "unit pitch W-PU". Description with reference to such unit pitch is included below. In FIG. 4, each pixel unit PXU includes two rows of light emitting areas arranged in the first direction, with the rows continuing to an adjacent pixel unit PXU. In this manner, the top row shown may include six light emitting areas, with a subset of those being in the top left pixel unit PXU, i.e., three of the six light emitting areas in the top row are in the top left pixel unit PXU.

In this embodiment, the first light emitting areas LA1-1 and LA1-2 may be areas where light generated from the first pixel is provided to the outside, the second light emitting areas LA2-1 and LA2-2 may be areas where light generated from the second pixel is provided to the outside, and the third light emitting areas LA3-1 and LA3-2 may be areas where light generated from the third pixel is provided to the outside. However, embodiments of the present disclosure are not limited thereto, and the types and quantity of light emitting areas constituting one pixel unit PXU may vary depending on display quality required for the display device.

FIG. 5A is an enlarged plan view of a partial area of FIG. 4. FIG. 5B is a sectional view corresponding to line I-I' of FIG. 5A. FIG. 5C is a sectional view corresponding to line II-II' of FIG. 5A.

For convenience of description, in FIG. 5A, a first light blocking pattern BM1 included in a first light control layer CCL1 is illustrated, and the shapes of second to fourth light blocking patterns BM2, BM3, and BM4 (refer to FIG. 5B) are omitted. However, the description of the first light blocking pattern BM1 given below with reference to FIGS. 5A to 6B may be identically or similarly applied to the second to fourth light blocking patterns BM2, BM3, and BM4 (refer to FIG. 5B), and repetitive description is omitted. Hereinafter, an arrangement of the light control layer and the light emitting areas, including a relationship between same, will be described with reference to the drawings.

FIG. 5A is a view illustrating an arrangement of and a relationship between the light emitting area LA and the first light blocking pattern BM1. FIG. 5B is a portion of a sectional view of the display device taken along line I-I' of FIG. 5A. For convenience of description, the window module WM (refer to FIG. 3) and the specific configuration of the input sensing layer ISL are omitted in FIG. 5B.

Referring to FIGS. 5A and 5B, the display element layer DP-ED may include a pixel defining layer PDL having the pixel opening OH defined therein and the light emitting element ED-1 disposed in the pixel opening OH. The light emitting element ED-1 may include a first electrode EL1, a second electrode EL2, and a hole transport layer HTR, a light emitting layer EML-R, an electron transport layer ETR that are disposed between the first electrode EL1 and the second electrode EL2 and a capping layer CPL disposed on the second electrode EL2.

The first electrode EL1 may be exposed by the pixel opening OH. The area where the first electrode EL1 is exposed by the pixel opening OH may be defined as the light emitting area LA (refer to FIG. 4).

The light control layer CCL may be disposed on the display panel DP. In the present disclosure, the light control layer CCL may include a plurality of layers. When the light control layer CCL includes a single layer, the effect of adjusting the viewing angle by the light control layer CCL may be reduced. When the light control layer CCL includes a plurality of layers, the thickness of the display device DD may be increased, and manufacturing costs may be increased. In this manner, it is advantageous to include at least two but less than or equal to five light control layers CCL.

In this embodiment, depicted in FIGs. 5A-5C, four light control layers CCL1, CCL2, CCL3, and CCL4 may be provided. The light control layers CCL1, CCL2, CCL3, and CCL4 may be sequentially stacked in a direction away from the display panel DP. The light control layers CCL1, CCL2, CCL3, and CCL4 may be sequentially arranged in the third direction DR3.

The first light control layer CCL1 may include the first light blocking pattern BM1 and a first insulating layer IL1. The second light control layer CCL2 may include the second light blocking pattern BM2 and a second insulating layer IL2. The third light control layer CCL3 may include the third light blocking pattern BM3 and a third insulating layer IL3. The fourth light control layer CCL4 may include the fourth light blocking pattern BM4 and a fourth insulating layer IL4. In some examples, the display device may include five light control layers.

The first light blocking pattern BM1 may include extensions PT1 and connections PT2. However, the extensions PT1 and the connections PT2 are distinguished from each other for convenience of description, and the first light blocking pattern BM1 may be provided as one continuous body. The extensions PT1 and the connections PT2 may be formed together through one process, e.g., may be formed simultaneously and may include the same material.

The extensions PT1 may have an elongate dimension that extends in the first direction DR1 and the extensions PT1 may be arranged such that each extension PT1 is spaced apart in the second direction DR2. The extensions PT1 may be spaced apart from one another at a predetermined interval L-PT1 in the second direction DR2. FIG. 5A illustrates an example where five extensions PT1 are disposed on the display device DD.

At least one connection PT2 may be disposed between two adjacent extensions PT1 of the extensions PT1, i.e., may be disposed between a pair of adjacent extensions. Accordingly, the two adjacent extensions PT1 may be connected through the connection PT2. Each of the connections PT2 may be directly connected with two extensions PT1. Throughout the present disclosure, the "connections PT2" may be also be referred to as a "binding pattern PT2".

In this embodiment, the connections PT2 may extend in the second direction DR2. The connections PT2 may be spaced apart from one another at a predetermined interval L-PT2 in the first direction DR1. The interval L-PT2 may be larger than the "minimum light emitting area width W-LA". The "minimum light emitting area width W-LA" may mean the smallest of the widths of the first-first to third-second light emitting areas LA1-1 to LA3-2 in the first direction DR1.

The angle between the extension direction, i.e., an elongate dimension of the connections PT2 and the first direction DR1 may be defined as a "connection angle AG". Although FIG. 5A illustrates an example that the connection angle AG is 90 degrees, embodiments of the present disclosure are not limited to the connection angle AG illustrated in FIG. 5A. For example, the extension direction of the connections PT2 may be transverse to the extension direction of the extensions PT1, e.g., at an acute angle or at an oblique angle.

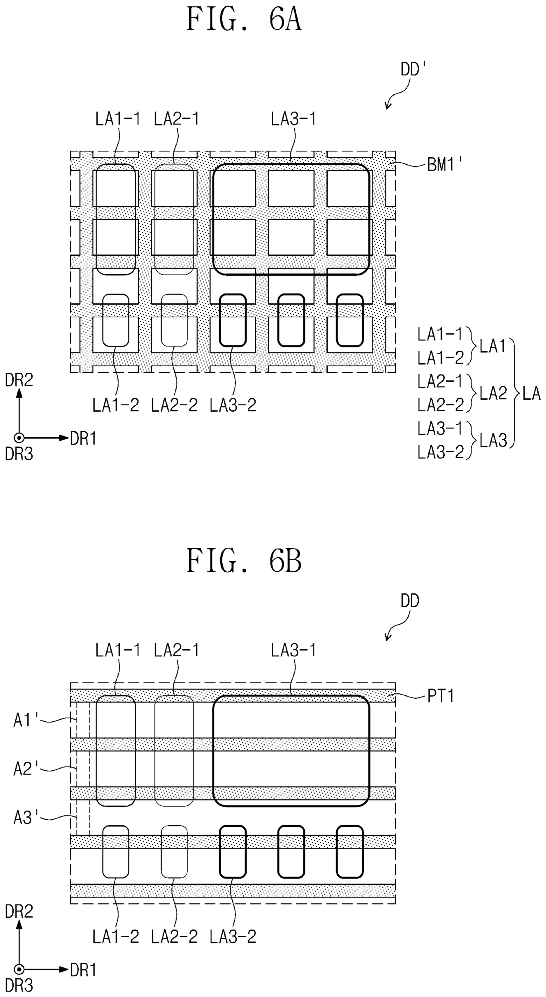

A light blocking pattern in the related art includes only connections in the form of "parallel lines" that extend in one direction and that are spaced apart from one another in a direction crossing the one direction or, as will be described below with reference to FIG. 6A, includes a portion extending in one direction and "mesh-shaped" connections extending in a direction crossing the one direction.

However, such arrangements may be prone to defects or failures. For example, in the case of the light blocking pattern disposed in the form of "parallel lines", adjacent connections may not be fixed to each other, and therefore some of the connections may be detached in a manufacturing process. In addition, in the case of the "mesh-shaped" connections, adjacent connections may be firmly fixed to each other, but the arrangement is subject to burdensome, i.e. high manufacturing costs and the use of such "mesh-shaped" connections produces an undesirable reduction in visibility of a display device.

The display device DD according to the present disclosure may include the extensions PT1 with respective elongate, or long dimensions that extend in the first direction DR1, and thus the cost required for the manufacturing process may be reduced. Furthermore, the display device DD according to the present disclosure may include the connections PT2 disposed between the adjacent extensions PT1 and thus, through such connections PT2, may effectively prevent some of the extensions PT1 from being detached. That is, each of the extensions PT1 according to the present disclosure may be connected with other extensions PT1 adjacent thereto through the connections PT2 and thus may be firmly fixed without being detached in the manufacturing process. In addition, unlike the "mesh-shaped" connections manufactured to have a structure as shown in FIG. 6A, for example, the connections PT2 are smaller in size than the extensions PT1, and thus manufacturing costs may be reduced, and the luminance of the display device may be prevented from being decreased.

Although omitted in FIGS. 5B and 5C for convenience of description, the input sensing layer ISL (refer to FIG. 3) may include conductive patterns. The input sensing layer ISL (refer to FIG. 3) may detect the contact of the user or an object with the display device DD by sensing a change in an electrical signal. In this case, the first light blocking pattern BM1 may be disposed on the input sensing layer ISL (refer to FIG. 3).

The display device DD according to an embodiment may further include an "inorganic protective film". The inorganic protective film may be disposed on the bottom of the first light blocking pattern BM1. The inorganic protective film may perform a function of protecting the bottom of the first light blocking pattern BM1 and may improve the adhesion of the bottom of the first light blocking pattern BM1.

Referring to FIGS. 5A and 5B, at least portions of each extension of the extensions PT1 may overlap the light emitting area LA when viewed from above the plane, i.e. in the third direction DR3. Portions of the extensions PT1 may overlap the light emitting area LA, and the remaining portions other than the portions of the extensions PT1 may not overlap the light emitting area LA.

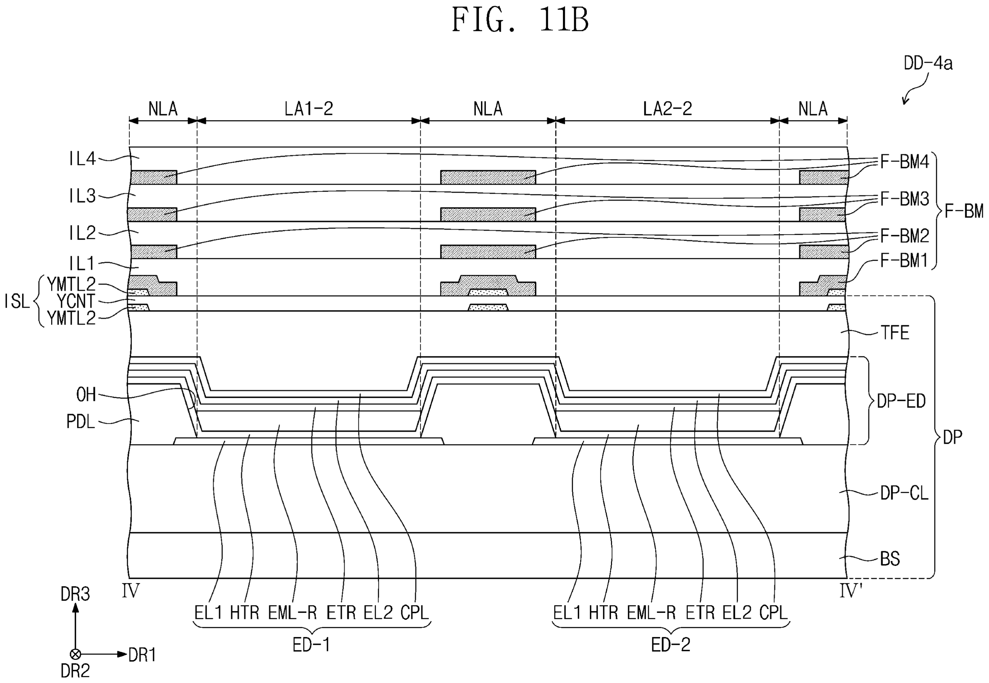

FIG. 5A illustrates an example where four extensions PT1 overlap all of the first to third light emitting areas LA1, LA2, and LA3. However, embodiments of the present disclosure are not limited thereto, and the extensions PT1 may overlap some of the first to third light emitting areas LA1, LA2, and LA3. For example, the extensions PT1 may overlap the first-first light emitting area LA1-1, the second-first light emitting area LA2-1, and the third-first light emitting area LA3-1 and may not overlap the first-second light emitting area LA1-2, the second-second light emitting area LA2-2, and the third-second light emitting area LA3-2. In this case, the display device DD according to the present disclosure may further include a light blocking barrier F-BM (refer to FIG. 11B) that is adjacent to the first-second light emitting area LA1-2, the second-second light emitting area LA2-2, and the third-second light emitting area LA3-2. Description thereof will be given below.

The connections PT2 may not overlap the light emitting area LA. Since the connections PT2 have a relatively small planar area when compared to the extensions PT1, the connections PT2 may be selectively disposed in the non-light emitting area NLA. FIG. 5C illustrates an example where the connections PT2 do not overlap the light emitting areas LA1-2, LA2-2, and LA3-2 and instead overlap the non-light emitting area NLA only. Accordingly, the display device DD according to embodiments of the present disclosure that includes the connections PT2 may prevent a reduction in luminance.

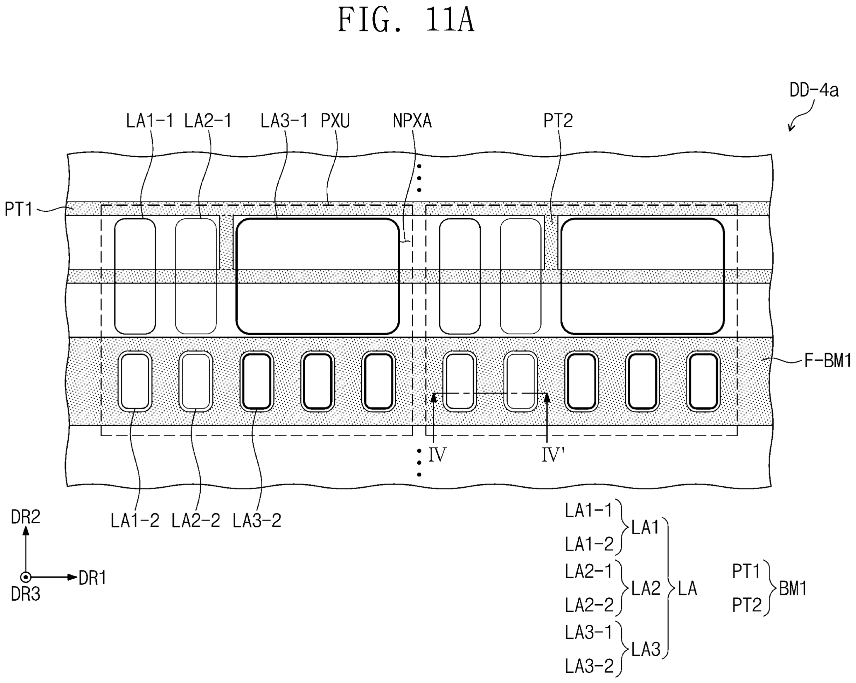

The connections PT2 disposed between the adjacent extensions PT1 may be spaced apart from each other such that at least one of the light emitting areas LA is disposed therebetween. However, embodiments of the present disclosure are not limited thereto. For example, and as shown in FIGs. 11A-11B for instance, the extensions PT1 may be arranged so that such extensions PT1 are not disposed between the first-second light emitting area LA1-2, the second-second light emitting area LA2-2, and the third-second light emitting area LA3-2. In this case, the display device DD according to the present disclosure may further include the light blocking barrier F-BM (refer to FIG. 11B) that overlaps the first-second light emitting area LA1-2, the second-second light emitting area LA2-2, and the third-second light emitting area LA3-2. Description thereof will be given below.

In this embodiment, and with continued reference to FIGs. 5A-5C, a connection PT2 adjacent to one of the connections PT2 and located in the "lower direction" with respect to the one connection PT2 may also be located in the "right direction" with respect to the one connection PT2. However, embodiments of the present disclosure are not limited to that illustrated in the Figures. For example, a connection PT2 located in the "lower direction" with respect to any one connection PT2 may be located in the "left direction" with respect to the one connection PT2.

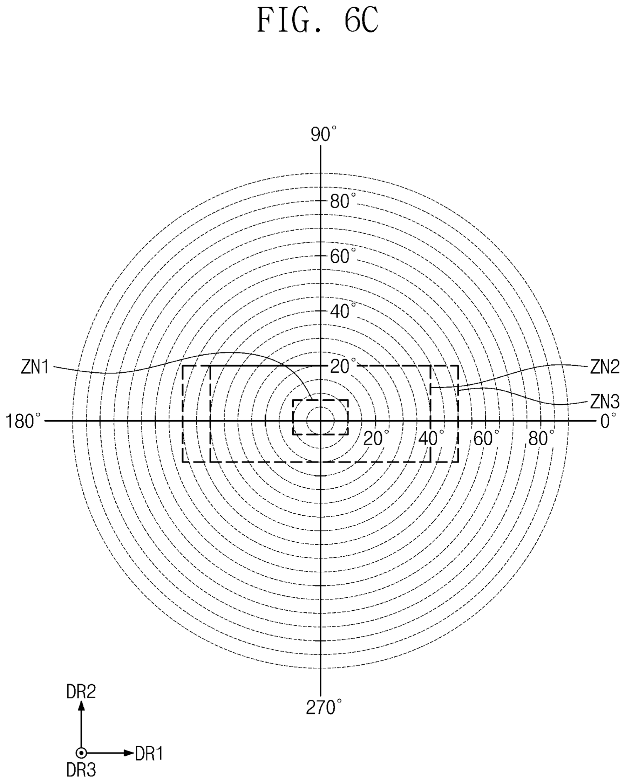

FIG. 6A is a plan view illustrating a partial area of a display device according to a comparative example. FIG. 6B is a plan view illustrating a partial area of a display device according to an embodiment of the present disclosure. FIG. 6C is a schematic view illustrating different viewing areas, i.e. ranges of angles within a field of view, according to the present disclosure.

Referring to FIG. 6A, the display device DD' according to the comparative example may include first to third light emitting areas LA1, LA2, and LA3, a portion extending in one direction, and a first light blocking pattern BM1' in a "mesh shape" that extends in a direction crossing the one direction.

Referring to FIG. 6B, a display device according to embodiment 1 may include the connection PT2 (refer to FIG. 5A) disposed in area A1', a display device according to embodiment 2 may include the connection PT2 (refer to FIG. 5A) disposed in area A2', and a display device according to embodiment 3 may include the connection PT2 (refer to FIG. 5A) disposed in area A3'.

Table 1 shows the "luminance reduction amounts" for respective areas of the display device DD' according to the comparative example and the display devices DD according to embodiments 1 to 3. Areas 1 to 3 of Table 1 are quantitative measurements of the luminance reduction amounts in predetermined areas when the display device according to the comparative example and the display devices according to embodiments 1 to 3 are viewed.

Referring to FIG. 6C and Table 1, "Area 1 ZN1" may mean an area having an angle of -10° to +10° in the horizontal direction and an angle of -4° to +8° in the vertical direction. "Area 2 ZN2" may mean an area having an angle of -40° to +40° in the horizontal direction and an angle of -10° to +20° in the vertical direction. "Area 3 ZN3" may mean an area having an angle of -50° to +50° in the horizontal direction and an angle of -10° to +20° in the vertical direction.

**[Table 1]**

| Classification | Comparative Example | Embodiment 1 | Embodiment 2 | Embodiment 3 |
|---|---|---|---|---|
| Luminance at 35° in up-down direction | 1.3% | 1.3% | 1.3% | 1.3% |
| Front blocking percentage | 60% | 60% | 60% | 60% |
| Area 1 | 40% | 40% | 40% | 40% |
| Area 2 | 15% | 13.5 % | 13.4% | 15% |
| Area 3 | 12% | 10.6 % | 10.5% | 12% |

In the display device DD' according to the comparative example and the display devices DD according to embodiments 1 to 3, the luminance at an angle of 35° in the up-down direction may be 5% or less of the luminance at an angle of 0° in the front direction. Referring to Table 1, it can be seen that in the display device DD' according to the comparative example and the display devices DD according to embodiments 1 to 3, the luminance at an angle of 35° in the up-down direction is 1.3% of the luminance at an angle of 0° in the front direction. In Table 1, the "front blocking percentage" may mean the percentage at which the light emitting area LA (refer to FIG. 5A) is blocked by the light blocking pattern when the display device is viewed from the front. The "front blocking percentage" is only affected by the extension PT1 without being affected by the connection PT2 (refer to FIG. 5A). Accordingly, in the comparative example and embodiments 1 to 3 of the present disclosure, the front blocking percentage may have the same value of 60%.

Referring to Table 1, it can be seen that the luminance reduction percentages of areas 1 to 3 in embodiments 1 to 3 range from a minimum of 0% to a maximum of 1.6%. That is, according to the present disclosure, it can be confirmed that the luminance reduction amount is equal to or smaller than the luminance reduction in the comparative example, regardless of whether the connection PT2 (refer to FIG. 5A) is disposed in area A1', area A2', or area A3'.

That is, these results confirm that the display device DD (refer to FIG. 5A) according to the present disclosure, inclusive of the connections PT2 (refer to FIG. 5A) disposed at positions not overlapping the light emitting area, is effective at minimization of the luminance reduction amount.

Hereinafter, display devices according to various embodiments of the present disclosure will be described with reference to the drawings.

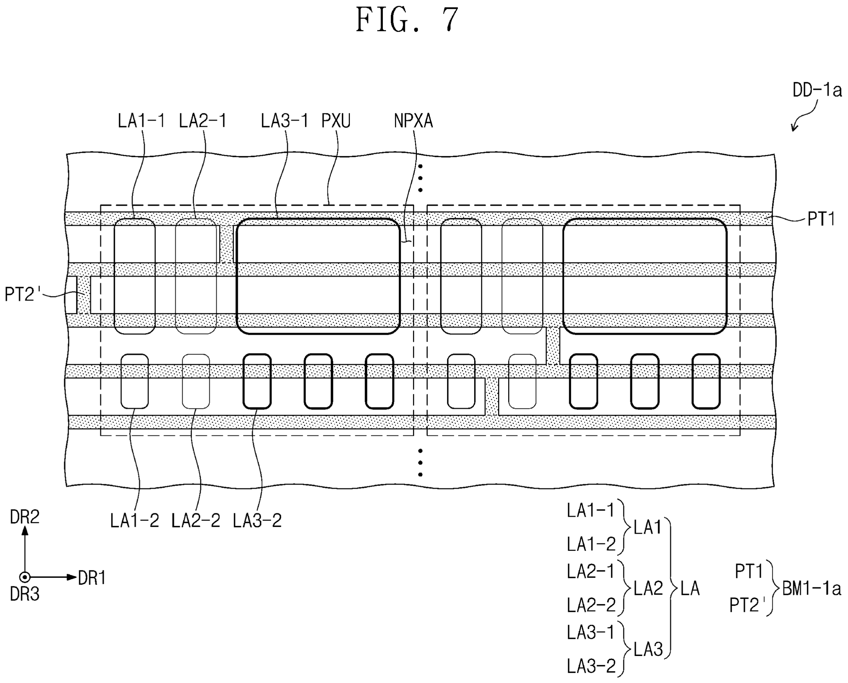

FIG. 7 is a plan view illustrating a partial area of a display device according to an embodiment of the present disclosure.

Components identical or similar to the components described with reference to FIGS. 3 to 5 will be assigned with identical or similar reference numerals in FIG. 7, and repetitive description will be omitted. The following description will be focused on differences with respect to the embodiment of FIGs. 3-5C.

FIG. 7 illustrates an arrangement of and a relationship between a light emitting area LA and a first light blocking pattern BM1-1a.

In the display device DD-1a according to an embodiment, connections PT2' may be outside of and not overlap the light emitting area LA, and at least one connection PT2' may be disposed between two adjacent extensions PT1.

However, the connections PT2' may be randomly disposed at positions not overlapping the light emitting area LA along the first direction DR1. Accordingly, the positions at which the connections PT2' are disposed in a display area AA may be distributed without being concentrated in a specific position along the first direction DR1.

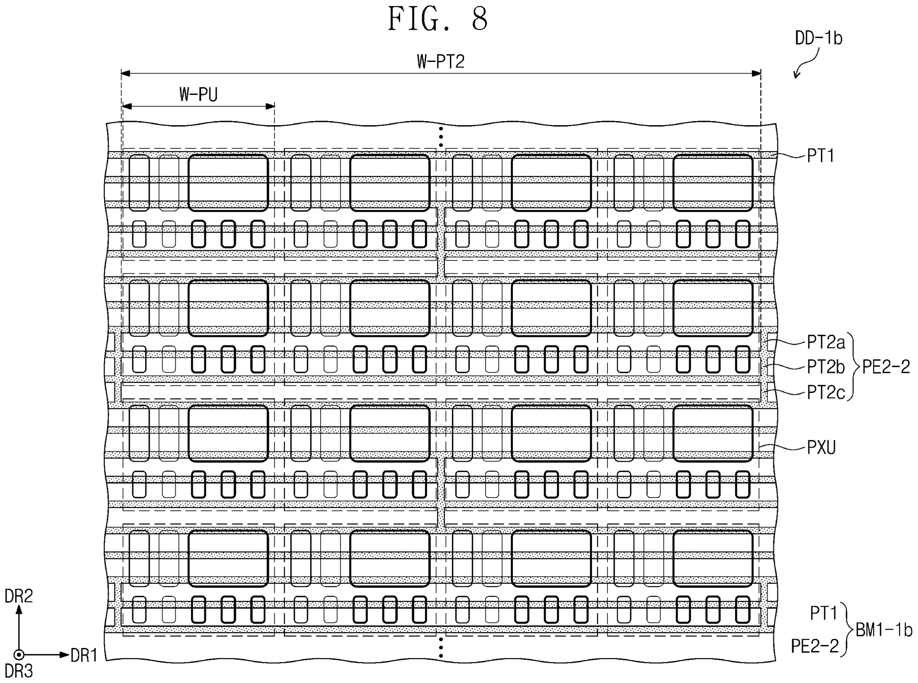

FIG. 8 is a plan view illustrating a partial area of a display device according to an embodiment of the present disclosure.

Components identical or similar to the components described with reference to FIGS. 3 to 5 will be assigned with identical or similar reference numerals in FIG. 8, and repetitive description will be omitted. The following description will be focused on a difference with respect to the embodiment of FIGs. 3-5C.

In the display device DD-1b according to an embodiment, a first light blocking pattern BM1-1b may include extensions PT1 and second expanding connections PE2-2. Throughout the present disclosure, an "expanding connection" may correspond to a connection that allows adjacent extensions PT1 to be continuously connected. In FIG. 8, each of the second expanding connections PE2-2 includes a first extending connection PT2a, a second extending connection PT2b, and a third extending connection PT2c disposed side by side in the second direction DR2 to connect four adjacent extensions PT1. The second expanding connections PE2-2 as shown are illustrated as an example.

However, the type of expanding connection is not limited thereto. For example, a component including two expanding connections disposed side by side in the second direction DR2 to connect three adjacent extensions PT1 may be included and may be defined as a "first expanding connection". Description thereof will be given below.

Referring to FIG. 8, the second expanding connections PE2-2 may be spaced apart from each other at a predetermined interval W-PT2 in the first direction DR1. FIG. 8 illustrates an example that the interval W-PT2 is substantially four unit pitches W-PU. However, the interval W-PT2 is not limited thereto. For example, the interval W-PT2 may be greater than or equal to one unit pitch W-PU and less than or equal to five unit pitches W-PU. In other examples, the interval W-PT2 may be greater than or equal to one unit pitch W-PU and less than or equal to four unit pitches W-PU.

In this embodiment, the second expanding connections PE2-2 may be disposed at the boundaries between the pixel units PXU (refer to FIG. 4). That is, the second expanding connections PE2-2 may not be disposed between, e.g., may be entirely outside of the first-first to third-second light emitting areas LA1-1 to LA3-2 (refer to FIG. 7) included in the pixel units PXU (refer to FIG. 4).

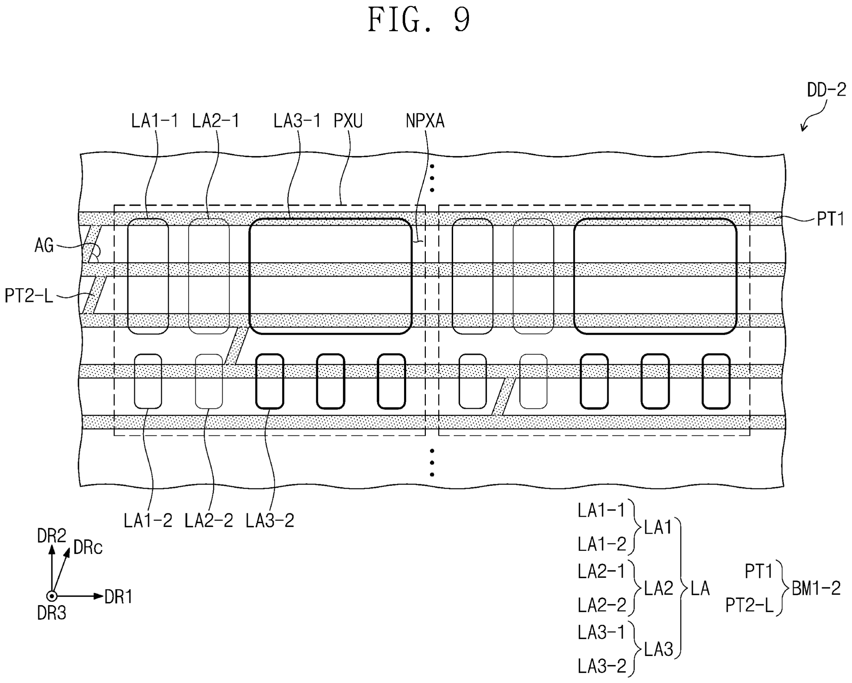

FIG. 9 is a plan view illustrating a partial area of a display device according to an embodiment of the present disclosure.

Components identical or similar to the components described with reference to FIG. 5A will be assigned with identical or similar reference numerals in FIG. 9, and repetitive description will be omitted. The following description will be focused on differences with respect to the embodiment of FIGs. 3-5C.

FIG. 9 is a view illustrating an arrangement of and relationship between a light emitting area LA and a first light blocking pattern BM1-2.

Connections PT2-L may not overlap, i.e., may be entirely outside of the light emitting area LA, and at least one connection PT2-L may be disposed between two adjacent extensions PT1.

Throughout the present disclosure, the extension direction, i.e., a direction of an elongate dimension of the connections PT2-L may be defined as a "connection direction DRc". The angle at which the first direction DR1 and the connection direction DRc cross each other may be defined as a "connection angle AG".

In this embodiment, the connection direction DRc may be a direction between the first direction DR1 and the second direction DR2. Accordingly, the connection angle AG may be an acute angle or an obtuse angle. FIG. 9 illustrates an example where the connection angle AG is an acute angle. However, embodiments of the present disclosure are not limited to that illustrated in the drawing, and the connection angle AG according to other examples may be an obtuse angle.

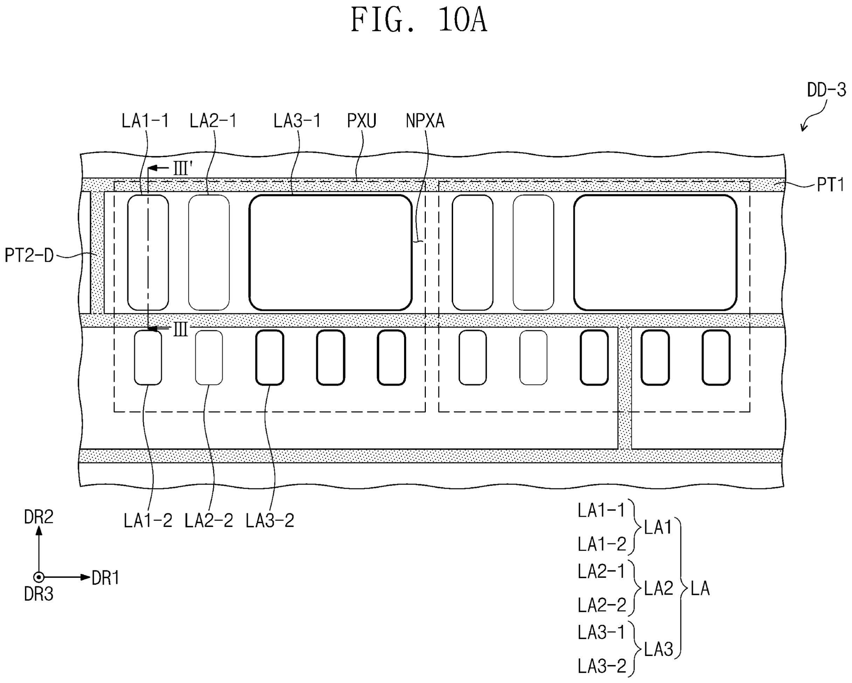

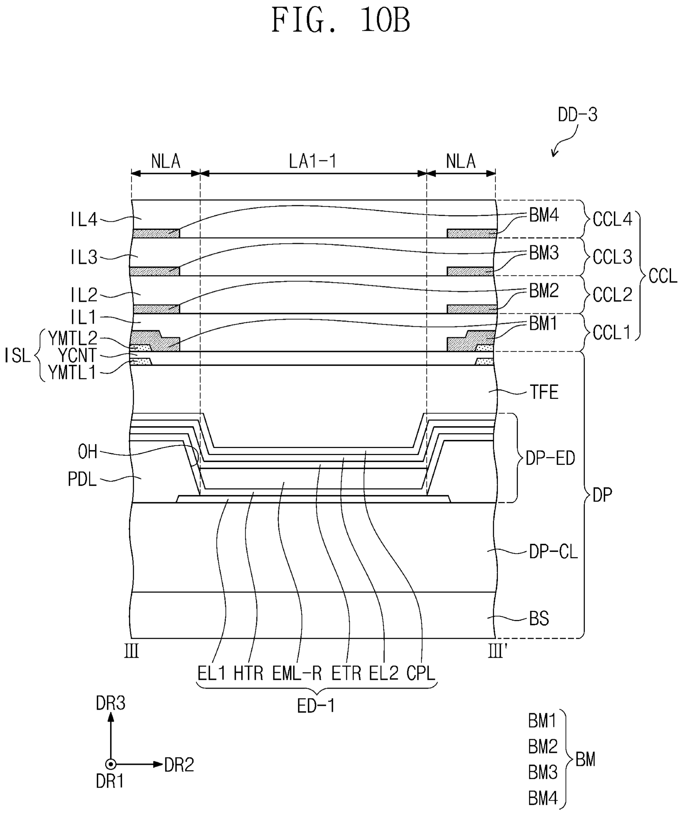

FIG. 10A is a plan view illustrating a partial area of a display device according to an embodiment of the present disclosure. FIG. 10B is a sectional view corresponding to line III-III' of FIG. 10A.

Components identical or similar to the components described with reference to FIGS. 5A and 5B will be assigned with identical or similar reference numerals in FIGs. 10A-10B, and repetitive description will be omitted. The following description will be focused on differences with respect to the embodiment of FIGs. 3-5C.

In this embodiment, extensions PT1 and extension connections PT2-D may not overlap a light emitting area LA. The extensions PT1 and extension connections PT2-D may not block light emitted from the light emitting area LA. The extensions PT1 and the extension connections PT2-D may be disposed in a non-light emitting area NLA when viewed from above a plane coincident with the first and second directions DR1, DR2, i.e., viewed in the third direction DR3.

The interval in the second direction DR2 between the extensions PT1 included in the display device DD-3 may be greater than the interval L-PT1 (refer to FIG. 5A) between the extensions PT1 (refer to FIG. 5A) included in the display device DD (refer to FIG. 5A).

In the display device DD-3 according to this embodiment, light emitted from the light emitting area LA may not be blocked by the connections PT1 and the extension connections PT2. Accordingly, the luminance of light emitted by the display device DD-3 may be increased relative to arrangements where connections block at least some of a light emitting area.

Referring to FIG. 10B, an input sensing layer ISL may include a first sensing conductive pattern YMTL1, a first sensing insulation layer YCNT that covers the first sensing conductive pattern YMTL1, and a second sensing conductive pattern YMTL2 disposed on the first sensing insulation layer YCNT.

In this arrangement, the shape of a first light blocking pattern BM1 may be modified to correspond to the shape of the sensing conductive pattern covered by the first light blocking pattern BM1. FIG. 10B illustrates an example where the shape of the first light blocking pattern BM1 is modified to correspond to the shape of the second sensing conductive pattern YMTL2.

FIG. 11A is a plan view illustrating a partial area of a display device according to an embodiment of the present disclosure. FIG. 11B is a sectional view corresponding to line IV-IV' of FIG. 11A.

Components identical or similar to the components described with reference to FIGS. 5A and 5B will be assigned with identical or similar reference numerals in FIGs. 11A-11B, and repetitive description will be omitted. The following description will be focused on differences with respect to the embodiment of FIGs. 3-5C.

The display device DD-4a according to this embodiment may further include the light blocking barrier F-BM. The light blocking barrier F-BM may be disposed on an encapsulation layer TFE. The light blocking barrier F-BM may be disposed adjacent to a first-second light emitting area LA1-2, a second-second light emitting area LA2-2, and a third-second light emitting area LA3-2. When viewed from above a plane, i.e., in the third direction DR3, the light blocking barrier F-BM according to this embodiment may have a shape that surrounds the first-second light emitting area LA1-2, the second-second light emitting area LA2-2, and the third-second light emitting area LA3-2.

Accordingly, the light blocking barrier F-BM may perform a function of narrowing the viewing angle of light emitted from the first-second light emitting area LA1-2, the second-second light emitting area LA2-2, and the third-second light emitting area LA3-2.

The display device DD-4a according to the present disclosure may limit the wide viewing angles of first-first light emitting areas LA1-1, second-first light emitting areas LA2-1, and third-first light emitting areas LA3-1 in the up-down direction through first extensions PT1. That is, the first extensions PT1 may perform a function of limiting the wide viewing angle of a "first type light emitting element" in the up-down direction.

In addition, the display device DD-4A according to the present disclosure may include the light blocking barrier F-BM and may perform a function of limiting the wide viewing angle in the up, down, left, and right directions. That is, the light blocking barrier F-BM may perform a function of limiting the wide viewing angle of a "second type light emitting element" in the up-down direction.

When the display device DD-4a according to the present disclosure operates in the "first mode", only the "first type light emitting element" may be driven. Light emitted from the "first type light emitting element" may be partially blocked by a first light blocking pattern BM1, and thus the wide viewing angle in the up-down direction may be limited. Alternatively, the "first type light emitting element" and the "second type light emitting element" may be driven. Light emitted from the "first type light emitting element" may be partially blocked by the first light blocking pattern BM1, and thus the wide viewing angle in the up-down direction may be limited. Light emitted from the "second type light emitting element" may be partially blocked by a first light blocking barrier F-BM1, and thus the wide viewing angle in the up, down, left, and right directions may be limited.

When the display device DD-4a according to the present disclosure operates in the "second mode", only the "second type light emitting element" may be driven. Accordingly, light emitted from the "second type light emitting element" may be partially blocked by the first light blocking barrier F-BM1, and thus the wide viewing angle in the up, down, left, and right directions may be limited.

Referring to FIG. 11B, the first to fourth light blocking barriers F-BM1, F-BM2, F-BM3, and F-BM4 may be sequentially stacked in the third direction DR3. The first to fourth light blocking barriers F-BM1, F-BM2, F-BM3, and F-BM4 may overlap one another when viewed from above the plane, i.e., when viewed in the third direction DR3.

The first to fourth light blocking barriers F-BM1, F-BM2, F-BM3, and F-BM4 may be formed through the same process as the first to fourth light blocking patterns BM1, BM2, BM3, and BM4 (FIG. 10B) and may include the same material as the first to fourth light blocking patterns BM1, BM2, BM3, and BM4 (FIG. 10B). In some examples, the light blocking barriers may be formed together with the light blocking patterns.

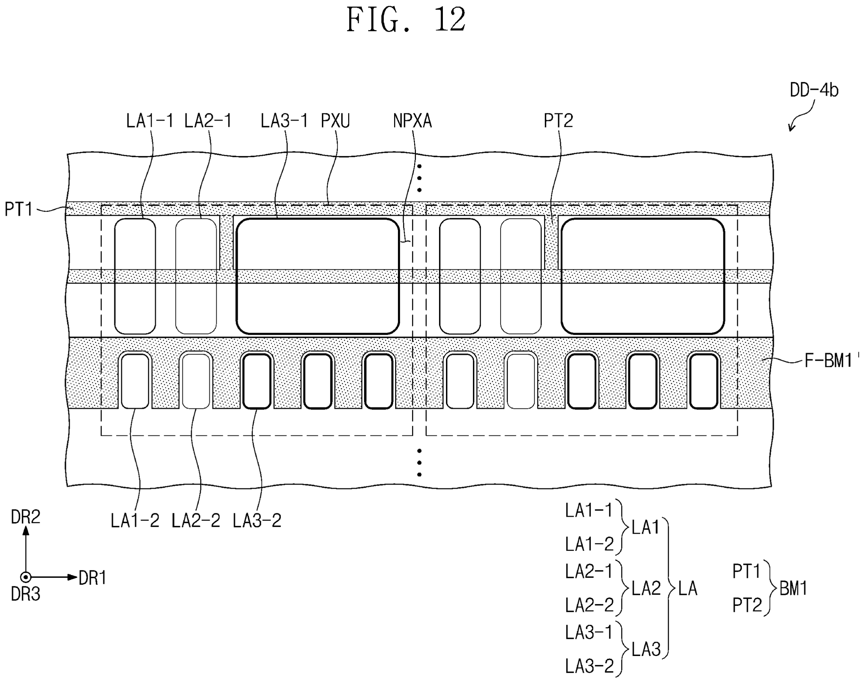

FIG. 12 is a plan view illustrating a partial area of a display device according to an embodiment of the present disclosure.

Components identical or similar to the components described with reference to FIGS. 5A, 5B, and 11A will be assigned with identical or similar reference numerals in FIG. 12, and repetitive description will be omitted. The following description will be focused on differences with respect to the embodiment of FIGs. 3-5C.

Referring to FIG. 12, the display device DD-4b according to this embodiment may include a first extension pattern (inclusive of extensions PT1), a second connection pattern (inclusive of connections PT2), and a first light blocking barrier F-BM1'.

When viewed from above a plane, i.e., in the third direction DR3, the first light blocking barrier F-BM1' according to this embodiment may have a shape that partially surrounds a first-second light emitting area LA1-2, a second-second light emitting area LA2-2, and a third-second light emitting area LA3-2. FIG. 12 illustrates an example where the first light blocking barrier F-BM1' does not surround lower portions of the first-second light emitting area LA1-2, the second-second light emitting area LA2-2, and the third-second light emitting area LA3-2.

Accordingly, the first light blocking barrier F-BM1' may not block light emitted in the lower direction among light emitted from the first-second light emitting area LA1-2, the second-second light emitting area LA2-2, and the third-second light emitting area LA3-2.

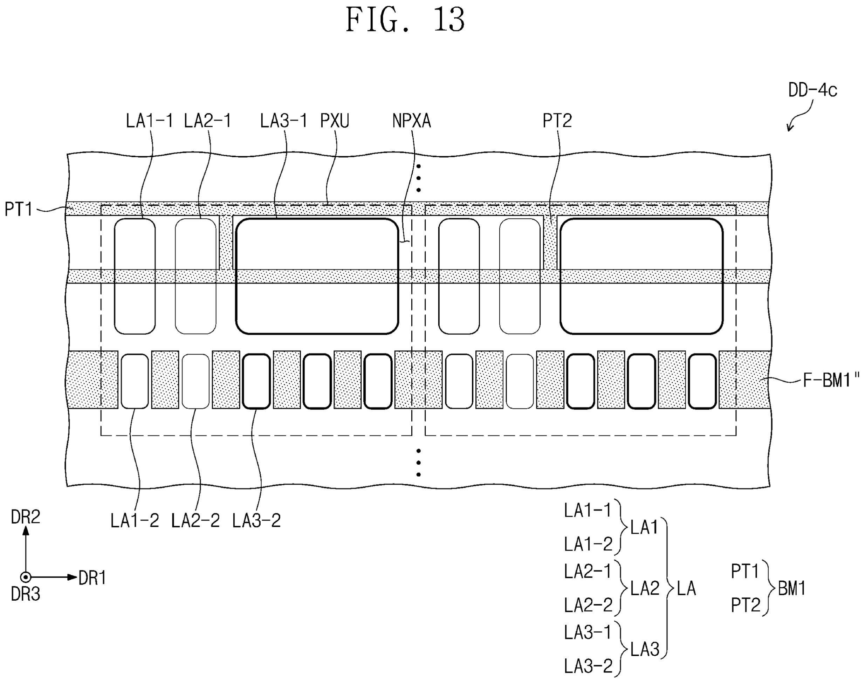

FIG. 13 is a plan view illustrating a partial area of a display device according to an embodiment of the present disclosure.

Components identical or similar to the components described with reference to FIGS. 5A, 5B, and 11A will be assigned with identical or similar reference numerals in FIG. 13, and repetitive description will be omitted. The following description will be focused on differences with respect to the embodiment of FIGs. 3-5C.

Referring to FIG. 13, the display device DD-4c according to this embodiment may include a first extension pattern, a second connection pattern, and a first light blocking barrier F-BM1".

When viewed from above a plane, i.e., in the third direction DR3, the first light blocking barrier F-BM1" according to this embodiment may be disposed between a first-second light emitting area LA1-2, a second-second light emitting area LA2-2, and a third-second light emitting area LA3-2.

Accordingly, the first light blocking barrier F-BM1" may not block light emitted in the upper direction and the lower direction among light emitted from the first-second light emitting area LA1-2, the second-second light emitting area LA2-2, and the third-second light emitting area LA3-2.

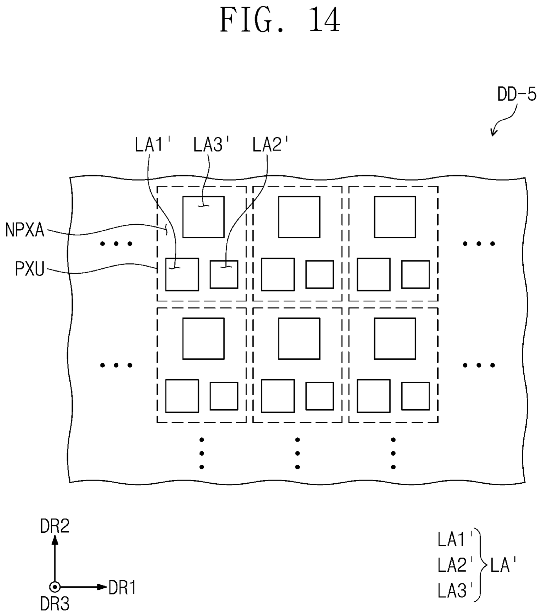

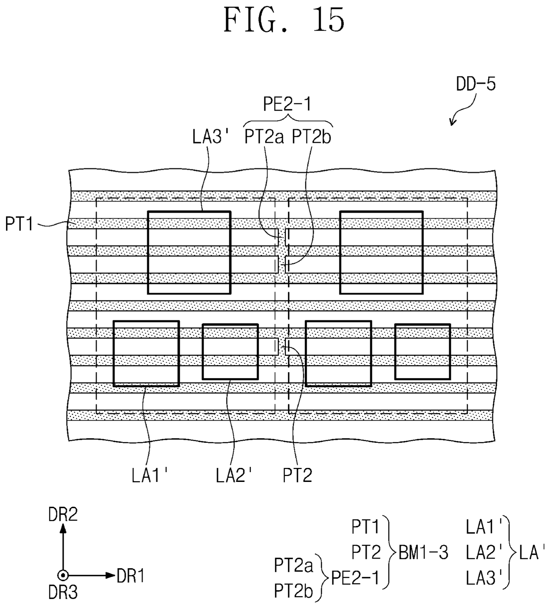

FIG. 14 is a plan view illustrating a partial area of a display device according to an embodiment of the present disclosure. FIG. 15 is an enlarged plan view of a partial area of FIG. 14.

In this embodiment, a light emitting area LA' may include a first light emitting area LA1', a second light emitting area LA2', and a third light emitting area LA3'. In this embodiment, red light may be provided through the first light emitting area LA1', green light may be provided through the second light emitting area LA2', and blue light may be provided through the third light emitting area LA3'. However, embodiments of the present disclosure are not limited thereto.

The first light emitting area LA1' may be disposed on the lower-left side with respect to the third light emitting area LA3', and the second light emitting area LA2' may be disposed on the lower-right side with respect to the third light emitting area LA3'.

The third light emitting area LA3' may have a larger planar area than the first light emitting area LA1' and the second light emitting area LA2'. The planar area may be in a plane perpendicular to the third direction DR3, as shown in FIG. 14. The planar area of light emitting areas may also be referred to as an emission surface area herein.

With reference to FIG. 15, a first light blocking pattern BM1-3 according to this embodiment may include an extension PT1, a connection PT2, and a first expanding connection PE2-1. However, this is only for the convenience of description, and the extension PT1, the connection PT2, and the first expanding connection PE2-1 may be integrally provided.

The first expanding connection PE2-1 may be disposed between adjacent third light emitting areas LA3'. The first expanding connection PE2-1 may overlap at least portions of extensions PT1 that in turn overlap the third light emitting areas LA3'. The first expanding connection PE2-1 may perform a function of connecting three to five adjacent extensions PT1.

The first expanding connection PE2-1 may include a plurality of extending connections PT2a and PT2b disposed side by side along the second direction DR2 so as to be adjacent to each other. The number of extending connections PT2a and PT2b may be one fewer than the number of extensions PT1 to be connected by the first expanding connection PE2-1.

FIG. 15 illustrates an example where the first expanding connection PE2-1 connects three extensions PT1 and includes two extending connections PT2a and PT2b. The first expanding connection PE2-1 may be connected with three adjacent extensions PT1, where the three adjacent extensions PT1 overlap the third light emitting area LA3.

The first expanding connection PE2-1 may include the first extending connection PT2a and the second extending connection PT2b. The first extending connection PT2a and the second extending connection PT2b may be disposed side by side between three adjacent extensions PT1.

The first expanding connection PE2-1 may be disposed between the light emitting areas LA3' having the largest planar area relative to other light emitting areas and may firmly connect the extensions PT1 overlapping the light emitting areas LA3'. Accordingly, the reliability of the first light blocking pattern BM1-3 may be improved.

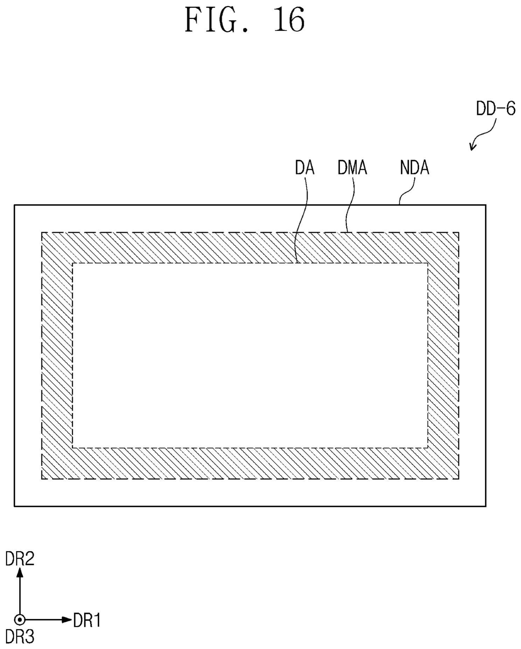

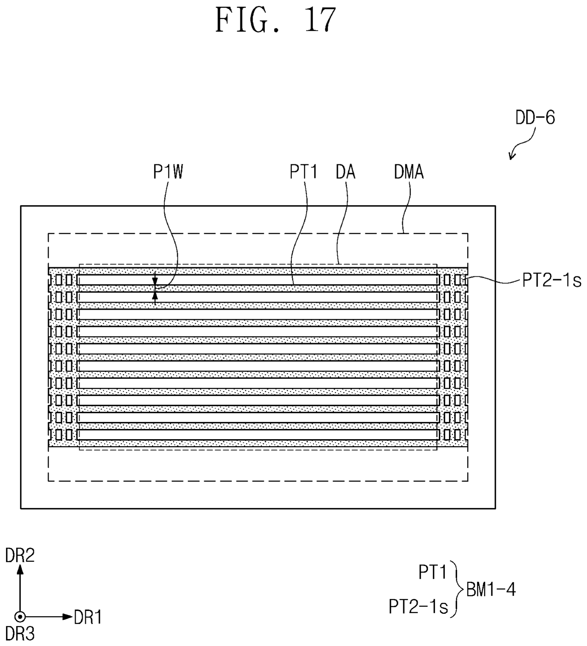

FIGS. 16 and 17 are plan views of a display device according to an embodiment of the present disclosure.

Referring to FIG. 16, the display device DD-6 according to this embodiment may include a display area DA and a non-display area NDA adjacent to the display area DA. The non-display area NDA may include a dummy area DMA that overlaps with the non-display area NDA and is adjacent to the display area DA.

In FIG. 17, extensions PT1 and first outer connections PT2-1s included in a first light blocking pattern BM1-4 are illustrated. However, the extensions PT1 and the first outer connections PT2-1s are distinguished from each other for convenience of description. The extensions PT1 and the first outer connections PT2-1s may be formed through one process and may include the same material.

The first outer connections PT2-1s may be disposed outside of the display area DA. The first outer connections PT2-1s may be disposed in the dummy area DMA. The first outer connections PT2-1s may be disposed between the extensions PT1.

Unlike the embodiment described with reference to FIG. 5A, the display device DD-6 according to this embodiment may include the connections concentrated in the non-display area NDA (refer to FIGs. 16 and 17). That is, since the first outer connections PT2-1s are disposed so as not to overlap the display area DA (refer to FIGs. 16 and 17), the display device DD-6 according to this embodiment may fundamentally prevent a luminance reduction phenomenon caused by the first outer connections PT2-1s. In addition, since the first outer connections PT2-1s are connected to all the extensions PT1, detachment of the extensions PT1 may be effectively reduced.

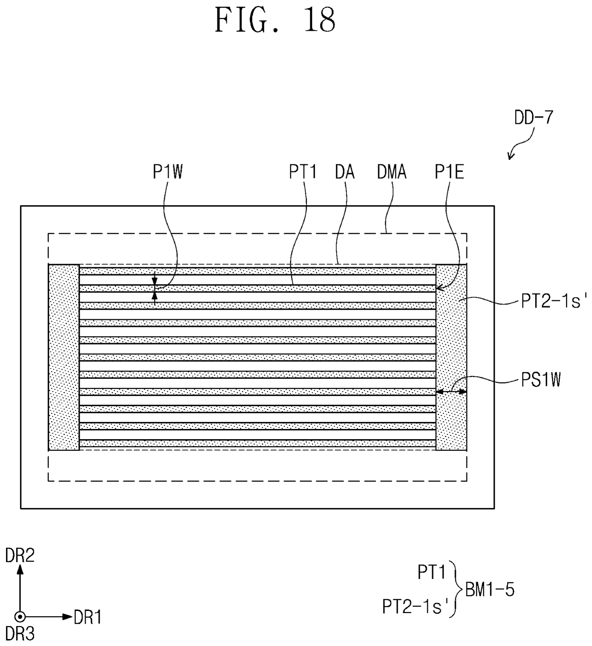

FIG. 18 is a plan view of a display device according to an embodiment of the present disclosure.

Referring to FIG. 18, the display device DD-7 according to this embodiment may include a display area DA and a non-display area adjacent to the display area DA. The non-display area may include a dummy area DMA overlapping the non-display area and adjacent to the display area DA.

In the display device DD-7 according to this embodiment, a first light blocking pattern BM1-5 may include extensions PT1 and first outer connections PT2-1s'. However, this is for convenience of description, and the extensions PT1 and the first outer connections PT2-1s' may be provided as one continuous body.

Components identical or similar to the components described with reference to FIGS. 16 and 17 will be assigned with identical or similar reference numerals in FIG. 18, and repetitive description will be omitted. The following description will be focused on differences with respect to the embodiment of FIGs. 16-17.

In this embodiment, each of the first outer connections PT2-1s' may be connected with ends P1E of the extensions PT1. The first outer connection PT2-1s' may be provided as one continuous body in the dummy area DMA.

In this embodiment, the widths PS1W of the first outer connections PT2-1s' in the first direction DR1 may be greater than the widths P1W of the extensions PT1 in the second direction DR2. For example, the first outer connections PT2-1s' may have a width PS1W in a range from 1400 µm to 1600 µm when viewed from above a plane, i.e., when viewed in the third direction DR3.

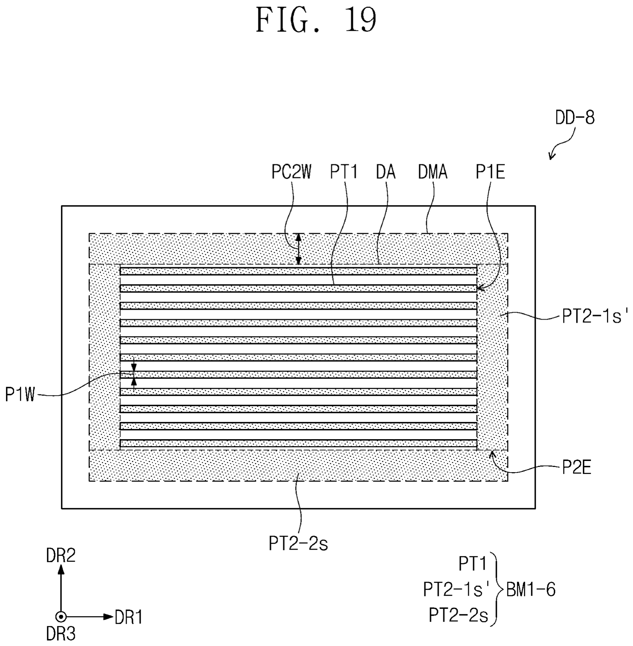

FIG. 19 is a plan view of a display device according to an embodiment of the present disclosure.

Components identical or similar to the components described with reference to FIGS. 16 to 18 will be assigned with identical or similar reference numerals in FIG. 19, and repetitive description will be omitted. The following description will be focused on differences with respect to the embodiments of FIGs. 16-18.

In this embodiment, a first light blocking pattern BM1-6 may include extensions PT1, first outer connections PT2-1s', and second outer connections PT2-2s. However, this is for convenience of description, and the extensions PT1, the first outer connections PT2-1s', and the second outer connections PT2-2s may be provided as one integral body.

The second outer connections PT2-2s may have an elongate dimension that extends in the first direction DR1. The second outer connections PT2-2s may be disposed in a dummy area DMA. The second outer connections PT2-2s may be connected with ends P2E of the first outer connections PT2-1s'.

One of the second outer connections PT2-2s may face the uppermost extension PT1 among the extensions PT1. The other one of the second outer connections PT2-2s may face the lowermost extension PT1 among the extensions PT1.

In this embodiment, the widths PC2W of the second outer connections PT2-2s may be greater than the widths P1W of the extensions PT1. For example, the second outer connections PT2-2s may have a width PC2W in a range from 2100 µm to 2300 µm when viewed from above a plane, i.e., when viewed in the third direction DR3.

The display device according to the present disclosure may have controlled lateral viewing angle characteristics. For example, the display device may be arranged so that a range of lateral viewing angles is limited in a predictable manner.

In addition, the display device according to the present disclosure may prevent a decrease in the luminance of the display device while also preventing a defect in the light blocking.

While the present disclosure has been described with reference to embodiments thereof, it will be apparent to those of ordinary skill in the art that various changes and modifications may be made thereto without departing from the scope of the present disclosure as defined in the appended claims.

## Claims

1. A display device (DD) comprising:
a display panel (DP) including a base layer (BL) including light emitting areas (LA) and a non-light emitting area (NLA), a pixel defining layer (PDL) disposed on the base layer (BL) and having pixel openings (OH) defined therein to overlap the light emitting areas (LA), and light emitting elements (OLED, ED) disposed in the pixel openings (OH); and
a light control layer (CCL) disposed on the display panel (DP) and including a light blocking pattern (BM),
wherein the light blocking pattern (BM) includes:
extensions (PT1), each extension (PT1) among the extensions (PT1) having an elongate dimension that extends in a first direction (DR1) to overlap the light emitting areas (LA) and the non-light emitting area (NLA), the extensions (PT1) being spaced apart in a second direction (DR2) perpendicular to the first direction (DR1); and
one or more connections (PT2) configured to overlap the non-light emitting area (NLA) without overlapping the light emitting areas (LA) and disposed between a first extension (PT1) and a second extension (PT1) from among the extensions (PT1), the first extension (PT1) and the second extension (PT1) being adjacent to each other.

2. The display device (DD) of claim 1, wherein the one or more connections (PT2) extend in the second direction (DR2).

3. The display device (DD) of claim 1 or 2, wherein an elongate dimension of each connection (PT2) among the connections (PT2) extends in an extension direction transverse to the first direction (DR1), and
wherein the extension direction of the connections (PT2) is at an acute angle relative to the first direction (DR1).

4. The display device (DD) of any one of the preceding claims, wherein the light control layer (CCL) is a first light control layer (CCL1) and the display device (DD) further comprises one or more additional light control layers (CCL), the one or more additional light control layers (CCL) including one or more of a second light control layer (CCL2), a third light control layer (CCL3), a fourth light control layer (CCL4) or a fifth light control layer (CCI5), the one or more additional light control layers (CCL) each including a light blocking pattern (BM),
wherein the first light control layer (CCL1) and the one or more additional light control layers (CCL) are sequentially disposed in a direction away from the display panel (DP),
wherein a total number of light control layers (CCL) in the display device (DD) does not exceed five.

5. The display device (DD) of claim 4, wherein the light blocking patterns (BM) included in the first light control layer (CCL1) and the one or more additional light control layers (CCL) overlap each other in a third direction (DR3) perpendicular to both the first direction (DR1) and the second direction (DR2).

6. The display device (DD) of any one of the preceding claims, wherein a luminance when the display panel (DP) is at an angle of 35° relative to the second direction (DR2) is 5% or less of a luminance of the display panel (DP) in a third direction (DR3) perpendicular to the first direction (DR1) and the second direction (DR2).

7. The display device (DD) of any one of the preceding claims, wherein the extensions (PT1) and the one or more connections (PT2) are formed together through a same process and both include a same material.

8. The display device (DD) of any one of the preceding claims, wherein each pair of adjacent extensions (PT1) of the extensions (PT1) are spaced apart from each other at a predetermined interval (L-PT1) in the second direction (DR2), and
wherein the one or more connections (PT2) include at least two connections (PT2), and each pair of adjacent connections (PT2) of the at least two connections (PT2) are spaced apart from each other at a predetermined interval (L-PT2) in the first direction (DR1).

9. The display device (DD) of any one of claims 1 to 8, wherein the light emitting elements (OLED, ED) include a first type of light emitting element (OLED, ED) and a second type of light emitting element (OLED, ED),
wherein the light emitting areas (LA) include a first-first light emitting area (LA1-1), a second-first light emitting area (LA2-1), and a third-first light emitting area (LA3-1) through which light by the first type of light emitting element (OLED, ED) is emitted and a first-second light emitting area (LA1-2), a second-second light emitting area (LA2-2), and a third-second light emitting area (LA3-2) through which light by the second type of light emitting element (OLED, ED) is emitted,
wherein the first-first light emitting area (LA1-1) has a larger emission surface area than the first-second light emitting area (LA1-2),
wherein the second-first light emitting area (LA2-1) has a larger emission surface area than the second-second light emitting area (LA2-2), and
wherein the third-first light emitting area (LA3-1) has a larger emission surface area than the third-second light emitting area (LA3-2).

10. The display device (DD) of claim 9, wherein the display device (DD) is configured to switch between a first mode in which only the first type of light emitting element (OLED, ED) operates and a second mode in which the first type of light emitting element (OLED, ED) does not operate and only the second type of light emitting element (OLED, ED) operates.

11. The display device (DD) of claim 9 or 10, further comprising:
a light blocking barrier (F-BM) disposed on the pixel defining layer (PDL) and configured to at least partially surround the first-second light emitting area (LA1-2), the second-second light emitting area (LA2-2), and the third-second light emitting area (LA3-2) when viewed in a third direction (DR3) perpendicular to both the first direction (DR1) and the second direction (DR2),
wherein the light blocking barrier (F-BM) and the light blocking pattern (BM) are formed together through a same process and the light blocking barrier (F-BM) and the light blocking pattern (BM) both include a same material.

12. The display device (DD) of any one of claims 1 to 8, wherein the light emitting areas (LA) include a first light emitting area (LA1) configured to emit red light, a second light emitting area (LA2) configured to emit green light, and a third light emitting area (LA3) configured to emit blue light, and
wherein the light blocking pattern (BM) further comprises a first expanding connection (PE2-1) that includes a first extending connection (PT2a) and a second extending connection (PT2b) disposed side by side in the second direction (DR2) to continuously connect three adjacent extensions (PT1) from among the extensions (PT1).

13. The display device (DD) of any one of the preceding claims, wherein the light blocking pattern (BM) further comprises second expanding connections (PE2-2), each second expanding connection (PE2-2) of the second expanding connections (PE2-2) including a first extending connection (PT2a), a second extending connection (PT2b), and a third extending connection (PT2c) disposed side by side in the second direction (DR2) to continuously connect four adjacent extensions (PT1) from among the extensions (PT1).

14. The display device (DD) of claim 13, wherein the display panel (DP) includes pixel units (PXU) arranged in the first direction (DR1), each pixel unit (PXU) of the pixel units (PXU) including a subset of light emitting elements (OLED, ED) from among the light emitting elements (OLED, ED),
wherein a width (W-PU) of the pixel units (PXU) in the first direction (DR1) is defined as a unit pitch (W-PU), and
wherein the second expanding connections (PE2-2) are spaced apart from each other at an interval of at least one unit pitch (W-PU) and no more than four unit pitches (W-PU) in the first direction (DR1).

15. A display device (DD) comprising:
a display panel (DP) including a display area (DA) and a non-display area (NDS) adjacent to the display area (DA); and
a first light control layer (CCL1) disposed on the display panel (DP) and including a light blocking pattern (BM) and an insulating layer (IL) arranged to cover the light blocking pattern (BM), the light blocking pattern (BM) comprising:
extensions (PT1) disposed in the display area (DA), each extension (PT1) having an elongate dimension that extends in a first direction (DR1), the extensions (PT1) being arranged so that the extensions (PT1) are spaced apart in a second direction (DR2) perpendicular to the first direction (DR1); and
first outer connections (PT2-1s) disposed in the non-display area (NDA), each first outer connection (PT2-1s) of the first outer connections (PT2-1s) being connected with ends (P1E) of the extensions (PT1), and
wherein a width (PS1W) of each first outer connection (PT2-1s) of the first outer connections (PT2-1s) is greater than a width (P1W) of each extension (PT1) of the extensions (PT1).

16. The display device (DD) of claim 15, wherein the extensions (PT1) and the first outer connections (PT2-1s) are formed together through a same process and both include a same material.

17. The display device (DD) of claim 15 or 16, wherein the light blocking pattern (BM) further comprises second outer connections (PT2-2s) disposed in the non-display area (NDA), each second outer connection (PT2-2s) of the second outer connections (PT2-2s) having an elongate dimension that extends in the first direction (DR1), the second outer connections (PT2-2s) being connected with ends (P2E) of the first outer connections (PT2-1s).

18. The display device (DD) of claim 17, wherein the first outer connections (PT2-1s) have a width (PS1W) in the first direction (DR1) that is in a range from 1400 µm to 1600 µm, and
wherein the second outer connections (PT2-2s) have a width (PC2W) in the second direction (DR2) that is in a range from 2100 µm to 2300 µm.

19. An electronic device (ED) comprising:
a display device (DD) of any one of the preceding claims;
an electronic module configured to provide an electrical signal to the display device (DD); and
a window module disposed on the display device (DD).

20. The electronic device (ED) of claim 19, further comprising:
a power supply module including power adaptor or a battery device,
wherein the electronic device (ED) is configured to be equipped in a transport device.
